(19) **Europäisches Patentamt / European Patent Office / Office européen des brevets**

(11) **EP 4 723 088 A1**

(12) **EUROPEAN PATENT APPLICATION**
published in accordance with Art. 153(4) EPC

(43) Date of publication:
**08.04.2026 Bulletin 2026/15**

(21) Application number: **23939428.1**

(22) Date of filing: **29.12.2023**

(51) International Patent Classification (IPC):
*G09G 3/3233* (2016.01)    *H10K 59/12* (2023.01)

(52) Cooperative Patent Classification (CPC):
**G09G 3/30; G09G 3/3225; G09G 3/3233; G09G 3/3266; G09G 3/3275; H10K 59/12**

(86) International application number:
**PCT/CN2023/143177**

(87) International publication number:
**WO 2024/244460 (05.12.2024 Gazette 2024/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.05.2023 CN 202310628545**

(71) Applicants:
• **Boe Technology Group Co., Ltd.**
**Beijing 100015 (CN)**
• **Chengdu BOE Optoelectronics Technology Co., Ltd.**
**Chengdu, Sichuan 611731 (CN)**

• **Beijing BOE Technology Development Co., Ltd.**
**Beijing 100176 (CN)**

(72) Inventors:
• **HUANG, Yao**
**Beijing 100176 (CN)**
• **DU, Mengmeng**
**Beijing 100176 (CN)**
• **FAN, Cong**
**Beijing 100176 (CN)**

(74) Representative: **Potter Clarkson**
**Chapel Quarter**
**Mount Street**
**Nottingham NG1 6HQ (GB)**

(54) **DISPLAY PANEL AND DISPLAY DEVICE**

(57) A display panel and a display device, relating to the technical field of display. The display panel comprises a plurality of pixel circuits distributed in an array; each pixel circuit comprises a plurality of transistors, a first capacitor (C1) and a second capacitor (C2); the transistors comprise a drive transistor (T3), a write transistor (T4), a light-emitting control transistor (T5), a first reset transistor (T1), a second reset transistor (T2), and a third reset transistor (T7). A substrate (SU), a semiconductor layer (SE) and a plurality of light-emitting devices (LD), wherein the semiconductor layer (SE) is arranged on one side of the substrate (SU) and comprises active parts of the transistors; the light-emitting devices (LD) are arranged on the side of the semiconductor layer (SE) away from the substrate (SU), and one light-emitting device (LD) is connected to a first electrode of the drive transistor (T3) of one pixel circuit; one of a first electrode plate (C11) and a second electrode plate (C12) of the first capacitor (C1) is arranged on the same layer as one of a first electrode plate (C21) and a second electrode plate (C22) of the second capacitor (C2); one of the first capacitor (C1) and the second capacitor (C2) overlaps the active part (ACT3) of the drive transistor (T3).

FIG. 5

## Description

## CROSS-REFERENCE TO RELATED APPLICATION

The present disclosure claims priority to Chinese Patent Application No. 202310628545.6, filed on May 30, 2023 and titled "Display Device, Display Panel, Pixel Circuit and Driving Method Therefor", the entire content of which is incorporated herein by reference in its entirety.

## TECHNICAL FIELD

The present disclosure relates to the field of display technology and particularly to a display panel and a display device.

## BACKGROUND

OLED (Organic Light Emitting Diode) display panels have advantages of self-illumination, wide color gamut, high contrast, flexibility and high response flexibility, and have a wide range of application prospects. However, uniformity of the luminous brightness of current display panels still needs to be improved, which may easily lead to abnormal image display.

It should be noted that the information disclosed in the Background is only used to enhance understanding of the background of the present disclosure, and therefore it may include information that does not constitute existing technology already known to those skilled in the art.

## SUMMARY

The present disclosure provides a display panel and a display device.

According to an aspect of the present disclosure, there is provided with a display panel, including: a plurality of pixel circuits arranged in array along a row direction and a column direction. Each pixel circuit includes a plurality of transistors, a first capacitor, and a second capacitor. The transistors include a drive transistor, a write transistor, a light-emitting control transistor, a first reset transistor, a second reset transistor, and a third reset transistor.

A first electrode of the light-emitting control transistor is configured to receive a first power signal, and a second electrode of the light-emitting control transistor is connected to a second electrode of the drive transistor; a first electrode of the write transistor is configured to receive a data signal, a second electrode of the write transistor is connected to a gate of the drive transistor and a first electrode plate of the first capacitor, a second electrode plate of the first capacitor is connected to a first electrode plate of the second capacitor, and a second electrode plate of the second capacitor is connected to a first electrode of the drive transistor.

A first electrode of the first reset transistor and a first electrode of the second reset transistor are configured to receive a reference signal, and a second electrode of the first reset transistor is connected to the gate of the drive transistor; a second electrode of the second reset transistor is connected to the second electrode plate of the first capacitor and the first electrode plate of the second capacitor; a first electrode of the third reset transistor is configured to receive a reset signal, and a second electrode of the third reset transistor is connected to the first electrode of the drive transistor and the second electrode plate of the second capacitor.

The display panel includes:

a substrate;
a semiconductor layer arranged on a side of the substrate and including an active part of each of the transistors; and
a plurality of light-emitting devices arranged on a side of the semiconductor layer away from the substrate, one of the light-emitting devices being connected to the first electrode of the drive transistor of one pixel circuit;
one of the first electrode plate and the second electrode plate of the first capacitor is arranged on a same layer as one of the first electrode plate and the second electrode plate of the second capacitor;
one of the first capacitor and the second capacitor overlaps with an active part of the drive transistor.

In an exemplary embodiment of the present disclosure, the first electrode plate of the first capacitor and the second electrode plate of the second capacitor are arranged on the same layer and distributed along the column direction; the second electrode plate of the first capacitor and the first electrode plate of the second capacitor are arranged on the same layer and have an integrated structure; the first electrode plate and the second electrode plate of the second capacitor overlap with the active part of the drive transistor.

In an exemplary embodiment of the present disclosure, the pixel circuit further includes a data control transistor, a first electrode of the data control transistor being connected to the second electrode of the write transistor and the first electrode plate of the first capacitor, and a second electrode of the data control transistor is connected to the gate of the drive transistor.

In an exemplary embodiment of the present disclosure, the semiconductor layer includes a first semiconductor part, a second semiconductor part, and a third semiconductor part spaced apart along the row direction; the second semiconductor part is located between the first semiconductor part and the third semiconductor part, and the first semiconductor part is connected to the second semiconductor part;
active parts of the write transistor, the data control transistor, and the first reset transistor are all located in the first semiconductor part and are sequentially connected along the column direction; an active part of the second reset transistor is located in the second semiconductor part; active parts of the light-emitting control transistor, the drive transistor, and the third reset transistor are located in the third semiconductor part and are sequentially connected along the column direction.

In an exemplary embodiment of the present disclosure, the third semiconductor part includes a first semiconductor segment and a second semiconductor segment distributed along the column direction; the active part of the drive transistor is connected between the first semiconductor segment and the second semiconductor segment;

a width of the active part of the drive transistor in the row direction is greater than a width of the first semiconductor segment in the row direction and a width of the second semiconductor segment in the row direction.

In an exemplary embodiment of the present disclosure, the width of the active part of the drive transistor in the row direction is not less than 6 $\mu$m and not greater than 20 $\mu$m.

In an exemplary embodiment of the present disclosure, the third semiconductor part includes a first semiconductor segment and a second semiconductor segment distributed along the column direction; the active part of the drive transistor is connected between the first semiconductor segment and the second semiconductor segment;

the active part of the drive transistor is bent towards the first semiconductor segment along the row direction.

In an exemplary embodiment of the present disclosure, a length of the active part of the drive transistor in the column direction is not less than 20 $\mu$m and not greater than 30 $\mu$m.

In an exemplary embodiment of the present disclosure, a width-to-length ratio of the drive transistor is not greater than 20/6 and not less than 4/30.

In an exemplary embodiment of the present disclosure, the first electrode plate of the first capacitor and the second electrode plate of the second capacitor are arranged on the same layer and distributed along the column direction; the second electrode plate of the first capacitor and the first electrode plate of the second capacitor are arranged on the same layer and have an integrated structure; the first electrode plate and the second electrode plate of the second capacitor overlap with the active part of the drive transistor.

In an exemplary embodiment of the present disclosure, the first electrode plate and the second electrode plate of the first capacitor overlap with the third semiconductor part and the first semiconductor part.

In an exemplary embodiment of the present disclosure, a capacitance of the second capacitor is greater than a capacitance of the first capacitor.

In an exemplary embodiment of the present disclosure, the display panel further includes:

a light-emitting control line extending along the row direction and overlapping with the active part of the light-emitting control transistor, and configured to transmit a light-emitting control signal;

a first reset control line extending along the row direction and overlapping with the active part of the third reset transistor, and configured to transmit a reset control signal;

a second reset control line connected to a gate of the first reset transistor and a gate of the second reset transistor and configured to transmit a reference control signal;

a scanning line extending along the row direction and connected to a gate of the write transistor, and configured to transmit a scanning signal;

a data control line extending along the row direction and connected to a gate of the data control transistor, and configured to transmit a data control signal;

a first reset line extending along the row direction and connected to the first electrode of the first reset transistor and the first electrode of the second reset transistor, and configured to transmit the reference signal; and

a second reset line extending along the row direction and connected to the first electrode of the third reset transistor, and configured to transmit the reset signal.

In an exemplary embodiment of the present disclosure, orthographic projections of the light-emitting control line, the scanning line, the data control line, the second reset control line, the first reset control line, and the second reset line on the substrate are sequentially spaced apart along the column direction; the first reset line overlaps with the first reset control line;

an orthographic projection of the active part of the drive transistor on the substrate is located between the orthographic projections of the data control line and the second reset control line on the substrate; orthographic projections of the active part of the write transistor and the first capacitor on the substrate are at least partially located between the orthographic projections of the light-emitting control line and the data control line on the substrate; orthographic projections of the active parts of the first reset transistor and the second reset transistor on the substrate are located between the orthographic projections of the data control line and the first reset control line on the substrate.

In an exemplary embodiment of the present disclosure, the display panel further includes:

a plurality of first auxiliary power lines extending along the row direction and distributed along the column direction, wherein one first auxiliary power line is provided between two adjacent rows of pixel circuits, and the first auxiliary power line is connected to the first electrode of the light-emitting control transistor of one row of pixel circuits on one side of the first auxiliary power line;

a plurality of first power lines arranged on a side of the first auxiliary power lines away from the substrate, wherein the first power line extend along the column direction and are spaced apart along the row direction, and one first power line is connected to each of the first auxiliary power lines and overlaps with one column of pixel circuits; and

a plurality of data lines arranged on the side of the first auxiliary power lines away from the substrate, wherein the data lines extend along the column direction and are spaced apart along the row direction, and one data line overlaps with one column of pixel circuits and is connected to the first electrode of the write transistor and is configured to transmit the data signal.

In an exemplary embodiment of the present disclosure, the display panel further includes:

a plurality of second power lines, a plurality of first auxiliary reset lines, and a plurality of second auxiliary reset lines, extending along the column direction, distributed along the row direction, and arranged on the side of the first auxiliary power lines away from the substrate, wherein each second power line is configured to transmit a second power signal, each first auxiliary reset line is connected to the first reset line, and each second auxiliary reset line is connected to the second reset line;

the first power line and the data line connected to a same column of pixel circuits are defined as a line group, and one of the second power line, the first auxiliary reset line, and the second auxiliary reset line is provided between two adjacent line groups;

the light-emitting device has a first electrode and a second electrode, the first electrode being connected to the first electrode of the drive transistor, and the second electrode being connected to the second power line.

In an exemplary embodiment of the present disclosure, the light-emitting control line includes a first light-emitting control subline and a second light-emitting control subline arranged along a direction away from the substrate, and both the first light-emitting control subline and the second light-emitting control subline extend along the row direction and are connected;

the first reset control line includes a first reset control subline and a second reset control subline arranged along the direction away from the substrate, and both the first reset control subline and the second reset control subline extend along the row direction and are connected.

In an exemplary embodiment of the present disclosure, the display panel further includes:

a light-shielding layer arranged on the side of the substrate and including the second electrode plate of the first capacitor and the first electrode plate of the second capacitor;

a first gate layer arranged on a side of the light-shielding layer away from the substrate and including the first electrode plate of the first capacitor, the second electrode plate of the second capacitor, the first light-emitting control subline, and the first reset control subline; the semiconductor layer being arranged on a side of the first gate layer away from the substrate;

a second gate layer arranged on the side of the semiconductor layer away from the substrate and including the second light-emitting control subline and the second reset control subline;

a first source-drain layer arranged on a side of the second gate layer away from the substrate and including the first auxiliary power line, the scanning line, the data control line, the second reset control line, the first reset line, and the second reset line; and a second source-drain layer arranged on a side of the first source-drain layer away from the substrate and including the data line, the first power line, the second power line, the first auxiliary reset line, and the second auxiliary reset line.

In an exemplary embodiment of the present disclosure, the first gate layer further includes:

a first gate part overlapping with the active part of the write transistor to form the gate of the write transistor;

a second gate part overlapping with the active part of the data control transistor, to form the gate of the data control transistor; the first electrode plate of the second capacitor including a third gate part; and

a fourth gate part overlapping with the active part of the first reset transistor and the active part of the second reset transistor, to form the gate of the first reset transistor and the gate of the second reset transistor.

In an exemplary embodiment of the present disclosure, the second gate layer includes:

a fifth gate part overlapping with the active part of the write transistor and connected to the first gate part, to form the gate of the write transistor;

a sixth gate part overlapping with the active part of the data control transistor and connected to the second gate part, to form the gate of the data control transistor;

a seventh gate part overlapping with the active part of the drive transistor and overlapping with the third gate part, to form the gate of the drive transistor; and

an eighth gate part overlapping with the active part of the first reset transistor and the active part of the second reset transistor and connected to the fourth gate part, to form the gate of the first reset transistor and the gate of the second reset transistor.

In an exemplary embodiment of the present disclosure, the first source-drain layer includes:

a first connection part located between the first auxiliary power line and the scanning line, and connected to the data line and the first electrode of the write transistor;

a second connection part located between the scanning line and the data control line, and connected to the first electrode plate of the first capacitor and a region of the first semiconductor part located between the active part of the write transistor and the active part of the data control transistor;

a third connection part located between the data control line and the second reset control line, and connected to the sixth gate part and a region of the first semiconductor part located between the active part of the first reset transistor and the active part of the data control transistor;

a fourth connection part located between the third connection part and the second reset control line, and connected to the first electrode plate of the second capacitor and an end of the second semiconductor part close to the active part of the drive transistor; an end of the second semiconductor part away from the active part of the drive transistor being connected to the first semiconductor part; and

a fifth connection part located between the first reset control line and the second reset control line, and connected to the second electrode plate of the second capacitor and a region of the third semiconductor part located between the active part of the drive transistor and the active part of the third reset transistor.

In an exemplary embodiment of the present disclosure, a material of the semiconductor layer includes a metal oxide.

According to an aspect of the present disclosure, there is provided with a display device, including the display panel according to any one of the above embodiments.

It should be understood that both the foregoing general description and the following detailed description are exemplary and explanatory only and are not restrictive of the present disclosure.

## BRIEF DESCRIPTION OF THE DRAWINGS

The accompanying drawings, which are incorporated in and constitute a part of this specification, illustrate embodiments consistent with the present disclosure and together with the description, serve to explain the principles of the present disclosure. Apparently, the drawings in the following description are only for illustrating some embodiments of the present disclosure and those skilled in the art may also derive other drawings based on the drawings without paying any creative effort.

FIG. 1 is a top view of an embodiment of a display panel of the present disclosure.
FIG. 2 is a schematic diagram of an embodiment of a pixel circuit of the present disclosure.
FIG. 3 is a timing diagram of an embodiment of a driving method for a pixel circuit of the present disclosure.
FIG. 4 is a partial sectional view of an embodiment of a display panel of the present disclosure.
FIG. 5 is a partial top view of a light-shielding layer to a second source-drain layer in a first embodiment of a display panel of the present disclosure.
FIG. 6 is a partial top view of a light-shielding layer to a first source-drain layer of a single pixel circuit in the first embodiment of the display panel according to the present disclosure.
FIG. 7 is a partial top view of a light-shielding layer to a second gate layer of a single pixel circuit in the first embodiment of the display panel according to the present disclosure.
FIG. 8 is a partial top view of a light-shielding layer to a semiconductor layer of a single pixel circuit in the first embodiment of the display panel according to the present disclosure.
FIG. 9 is a partial top view of a light-shielding layer to a first gate layer of a single pixel circuit in the first embodiment of the display panel according to the present disclosure.
FIGS. 10-15 are partial top views of various layers from a light-shielding layer to a second source-drain layer of a single pixel circuit in the first embodiment of the display panel according to the present disclosure.
FIG. 16 is a partial top view of a light-shielding layer to a second source-drain layer of a single pixel circuit in a second embodiment of a display panel of the present disclosure.
FIG. 17 is a partial top view of a light-shielding layer to a first source-drain layer of a single pixel circuit in the second embodiment of the display panel according to the present disclosure.
FIG. 18 is a partial top view of a light-shielding layer to a second gate layer of a single pixel circuit in the second embodiment of the display panel according to the present disclosure.
FIG. 19 is a partial top view of a light-shielding layer to a semiconductor layer of a single pixel circuit in the second embodiment of the display panel according to the present disclosure.
FIG. 20 is a partial top view of a light-shielding layer to a first gate layer of a single pixel circuit in the second embodiment of the display panel according to the present disclosure.
FIGS. 21-26 are partial top views of various layers from a light-shielding layer to a second source-drain layer of a single pixel circuit in the second embodiment of the display panel according to the present disclosure.

FIG. 27 is a partial top view of a light-shielding layer to a second source-drain layer of a plurality of pixel circuits in the first embodiment of the display panel according to the present disclosure.

FIG. 28 is a partial top view of a light-shielding layer to a first source-drain layer of a plurality of pixel circuits in the first embodiment of the display panel according to the present disclosure.

FIG. 29 is a partial top view of a light-shielding layer to a second gate layer of a plurality of pixel circuits in the first embodiment of the display panel according to the present disclosure.

FIG. 30 is a partial top view of a light-shielding layer to a semiconductor layer of a plurality of pixel circuits in the first embodiment of the display panel according to the present disclosure.

FIG. 31 is a partial top view of a light-shielding layer to a first gate layer of a plurality of pixel circuits in the first embodiment of the display panel according to the present disclosure.

FIGS. 32 to 37 are partial top views of various layers from a light-shielding layer to a second source-drain layer of a plurality of pixel circuits in the first embodiment of the display panel according to the present disclosure.

FIG. 38 is a partial top view of a light-shielding layer to a second source-drain layer of a plurality of pixel circuits in the second embodiment of the display panel according to the present disclosure.

FIG. 39 is a partial top view of a light-shielding layer to a first source-drain layer of a plurality of pixel circuits in the second embodiment of the display panel according to the present disclosure.

FIG. 40 is a partial top view of a light-shielding layer to a second gate layer of a plurality of pixel circuits in the second embodiment of the display panel according to the present disclosure.

FIG. 41 is a partial top view of a light-shielding layer to a semiconductor layer of a plurality of pixel circuits in the second embodiment of the display panel according to the present disclosure.

FIG. 42 is a partial top view of a light-shielding layer to a first gate layer of a plurality of pixel circuits in the second embodiment of the display panel according to the present disclosure.

FIGS. 43-48 are partial top views of various layers from a light-shielding layer to a second source-drain layer of a plurality of pixel circuits in the second embodiment of the display panel according to the present disclosure.

## DETAILED DESCRIPTION

Now, the exemplary embodiments will be described more fully with reference to the accompanying drawings. However, the exemplary embodiments may be embodied in a variety of forms and should not be construed as limiting the embodiments set forth herein. Instead, these embodiments are provided so that the present disclosure will be thorough and complete, and the concepts of the exemplary embodiments will be fully given to those skilled in the art. Same reference numbers denote the same or similar structures in the figures, and thus the detailed description thereof will be omitted. In addition, the drawings are merely schematic illustrations of the present disclosure, and are not necessarily drawn to scale.

Words such as "one," "an/a," "the" and "said" are used herein to indicate the presence of one or more elements/component parts/and others. Terms "including" and "having" have an inclusive meaning which means that there may be additional elements/component parts/and others in addition to the listed elements/component parts/and others. Terms "first," "second" and "third" are used herein only as markers, and they do not limit the number of objects modified after them.

A row direction X and a column direction Y herein are two intersecting directions, and in the accompanying drawings of the present disclosure, the row direction X is a horizontal direction and the column direction Y is a vertical direction, which are perpendicular to each other, but are not limited thereto; and the row direction X and the column direction Y may also be non-perpendicular directions. In addition, those skilled in the art may understand that as a display panel is rotated, actual orientations of the row direction X and the column direction Y may change, but their relative positions remain unchanged.

Feature A "overlapping with" feature B herein means that an orthographic projection of feature A on a plane at least partially overlaps with an orthographic projection of feature B on the plane. The plane may be a surface of a substrate or may be other planes parallel to the substrate.

Feature A and feature B "being arranged in a same layer" herein means that A and B belong to different continuous or continuous areas in a same film layer, and the film layer may be a single-layer structure; alternatively, the film layer may be a multi-layer structure, in which case A and B may be in a same layer or different layers among the a plurality of layers.

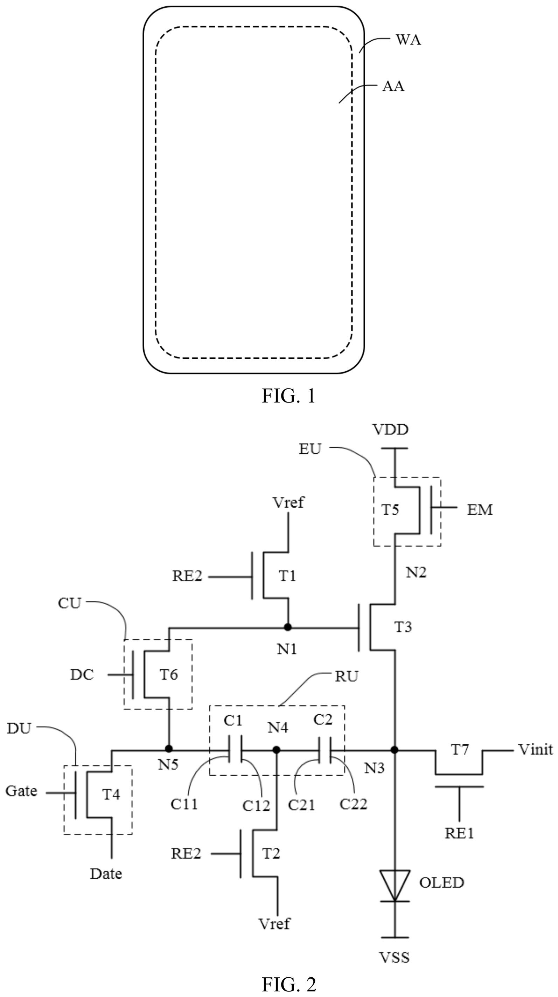

As shown in FIG. 1, the present disclosure provides a display panel that may include a display area AA and a peripheral area WA outside the display area AA. The peripheral area WA may be a continuous annular area surrounding the display area AA; or may be an area discontinuously surrounding the display area AA.

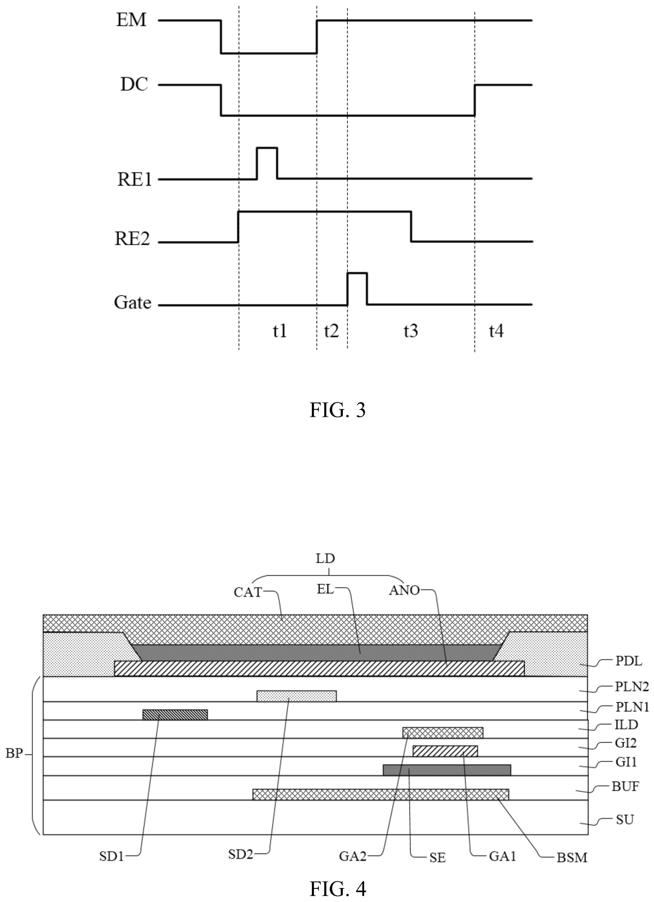

As shown in FIG. 4, the display panel may include a drive backplane BP and a plurality of light-emitting devices LD arranged at a side of the drive backplane BP. The light-emitting devices LD may be distributed in an array along the row direction X and the column direction Y, and through a drive circuit in the drive backplane BP, the light-emitting devices LD may be driven to emit light so as to display images.

As shown in FIG. 4, the light-emitting devices LD may be located in the display area AA and each may be an OLED (organic light-emitting diode) of an organic light-emitting material, or may be a LED (light-emitting diode) of an inorganic light-emitting material, such as Micro LED and Mini LED, or may be a device such as QLED (quantum dot diode). The specific structure of the light-emitting device LD is not specifically limited here, as long as it may display images.

As shown in FIG. 4, the light-emitting device LD using OLED is taken as an example, and may include a first electrode ANO, a light-emitting layer EL, and a second electrode CAT stacked sequentially along a direction away from the drive backplane BP. By applying electrical signals to the first electrode ANO and the second electrode CAT, the light-emitting layer EL may be excited to emit light. The specific principle of light emission will not be described in detail here.

The drive circuit may include a pixel circuit located in the display area AA and a peripheral circuit located in the peripheral area WA. The pixel circuit may be distributed along the row direction X and the column direction Y. One pixel circuit may be connected to the first electrode ANO of one light-emitting device LD. One row of pixel circuits may be connected to the first electrode ANO of each light-emitting device LD in one row. Certainly, one pixel circuit may also be connected to first electrodes ANO of a plurality of light-emitting devices LD. In addition, there may also be some pixel circuits located in the peripheral area WA.

The peripheral circuit may be connected to the light-emitting device LD through the pixel circuit, and a first power signal VDD may be applied to the first electrode ANO of the light-emitting device LD. On the other hand, the peripheral circuit may also be connected to the second electrode CAT of the light-emitting device LD, and a second power signal VSS may be applied to the second electrode CAT. Current passing through the light-emitting device LD may be controlled by the pixel circuit, and hence brightness of the light-emitting device LD may be controlled.

Taking one pixel circuit as an example, as shown in FIG. 2, the pixel circuit may include a drive transistor T3, an energy-storage circuit RU, a write circuit DU, and a light-emitting control circuit EU.

A gate of the drive transistor T3 is connected to a first electrode of the drive transistor T3 through the energy-storage circuit RU; a first electrode of the drive transistor T3 is used to be connected to the light-emitting device LD; and a second electrode of the drive transistor T3 is connected to the light-emitting control circuit EU and used to receive the first power signal VDD.

The write circuit DU is connected to the first electrode of the drive transistor T3 through the energy-storage circuit RU; the write circuit DU is used to write a data signal Data into the energy-storage circuit RU; and the energy-storage circuit RU is used to store the data signal Data and a voltage of the first electrode of the drive transistor T3.

The energy-storage circuit RU may separately store the data signal Data and the voltage of the first electrode of the drive transistor T3, to stabilize a voltage difference between the first electrode and the gate of the drive transistor T3, which may avoid mutual interference between the two. The write circuit DU may control the writing and interception of the data signal Data.

The energy-storage circuit RU may be implemented by a plurality of capacitors, while the write circuit DU may be implemented by transistors. For example: As shown in FIG. 2, in some embodiments of the present disclosure, the energy-storage circuit RU may include a first capacitor C1 and a second capacitor C2 connected in series; the write circuit DU may include a write transistor T4; and the light-emitting control circuit EU may include a light-emitting control transistor T5.

A first electrode of the write transistor T4 is used to input the data signal Data, and a second electrode of the write transistor T4 is connected to the gate of the drive transistor T3 and a first electrode plate C11 of the first capacitor C1; a second electrode plate C12 of the first capacitor C1 is connected to a first electrode plate C21 of the second capacitor C2; a second electrode plate C22 of the second capacitor C2 is connected to the first electrode of the drive transistor T3. A first electrode of the light-emitting control transistor T5 is used to receive the first power signal VDD, and a second electrode thereof may be connected to the second electrode of the drive transistor T3. The first electrode of the drive transistor T3 and the second electrode plate C22 of the second capacitor C2 may be connected to the first electrode ANO of the light-emitting device LD.

Further, in some embodiments, the display panel may further include a data control circuit CU, which may be connected to the gate and the first electrode of the drive transistor T3, and a second electrode of the write circuit DU may be connected to the gate of the drive transistor T3 and the energy-storage circuit RU through the data control circuit CU. By using the data control circuit CU, the gate of the drive transistor T3 and the write circuit DU may be connected and disconnected, and the gate of the drive transistor T3 and the energy-storage circuit RU may be connected and disconnected, which may prevent the data signal Data from being directly written into the gate of the drive transistor T3 and causing interference to a voltage of the first electrode, thereby preventing significant differences between actual brightness and design brightness of the light-emitting device LD due to different degrees of interference from the data signal Data, so as to improve image quality.

The data control circuit CU may also be implemented through transistors. For example: As shown in FIG. 2, in some embodiments of the present disclosure, the energy-storage circuit RU may include the first capacitor C1 and the second capacitor C2 connected in series; the data control circuit CU may include a data control transistor T6; and the write circuit DU may include the write transistor T4.

The first electrode of the write transistor T4 is used to input the data signal Data, and the second electrode of the write transistor T4 is connected to a first electrode of the data control transistor T6 and the first electrode plate C11 of the first capacitor C1 and may be connected at an N5 node; a second electrode of the data control transistor T6 is connected to the gate of the drive transistor T3 and may be connected at an N1 node; the second electrode plate C12 of the first capacitor C1 is connected to the first electrode plate C21 of the second capacitor C2 and may be connected at an N4 node; the second electrode plate C22 of the second capacitor C2 is connected to the first electrode of the drive transistor T3 and may be connected at an N3 node.

A gate of the write transistor T4 may receive a scanning signal Gate and be turned on or off under the control of the scanning signal Gate. A gate of the data control transistor T6 may receive a data control signal DC and be turned on or off under the control of the data control signal DC.

In addition, the light-emitting control circuit EU may control the access and interception of the first power signal VDD, and may also be implemented through transistors, for example:

As shown in FIG. 2, in some embodiments of the present disclosure, the light-emitting control circuit EU may include the light-emitting control transistor T5, the first electrode of which is used to receive the first power signal VDD, and the second electrode of which may be connected to the second electrode of the drive transistor T3; and the second electrode and the second electrode of the drive transistor T3 may be connected at an N2 node.

A gate of the light-emitting control transistor T5 may receive a light-emitting control signal EM and be turned on or off under the control of the light-emitting control signal EM.

In order to eliminate influence of a signal from a previous frame of image, the gate and the first electrode of the drive transistor T3 may be reset before displaying signal input of a current frame and, meanwhile, the energy-storage circuit RU may also be reset. As shown in FIG. 2, in some embodiments of the present disclosure, the pixel circuit may further include a first reset transistor T1 and a second reset transistor T2.

A first electrode of the first reset transistor T1 is used to receive a reference signal Vref, and a second electrode thereof is connected to the gate of the drive transistor T3 and the second electrode of the data control transistor T6. As shown in FIG. 2, the second electrode of the first reset transistor T1 is connected to the gate of the drive transistor T3 and the second electrode of the data control transistor T6 at the N1 node.

A first electrode of the second reset transistor T2 is used to receive the reference signal Vref, and a second electrode of the second reset transistor T2 is connected to the second electrode plate C12 of the first capacitor C1 and the first electrode plate C21 of the second capacitor C2. As shown in FIG. 2, the second electrode of the second reset transistor T2 is connected to the second electrode plate C12 of the first capacitor C1 and the first electrode plate C21 of the second capacitor C2 at the N4 node.

A gate of the first reset transistor T1 and a gate of the second reset transistor T2 may receive a reference control signal RE2 and be turned on or off under the control of the reference control signal RE2. That is, the first reset transistor T1 and the second reset transistor T2 may be synchronously turned on or off, and both may be controlled by the same signal. Certainly, the gate of the first reset transistor T1 and the gate of the second reset transistor T2 may receive the reference control signal RE2 through a same signal line or different signal lines.

The reference signal Vref may be input to the N1 node and the N4 node through the first reset transistor T1 and the second reset transistor T2, eliminating the influence of the signal when displaying the previous frame of image.

Further, as shown in FIG. 2, the pixel circuit also includes a third reset transistor T7, a first electrode of which is used to receive a reset signal Vinit, and a second electrode of which is connected to the first electrode of the drive transistor T3 and the second electrode plate C22 of the second capacitor C2. As shown in FIG. 2, the second electrode of the third reset transistor T7 is connected to the first electrode of the drive transistor T3 and the second electrode plate C22 of the second capacitor C2 at the N3 node. A gate of the third reset transistor T7 may receive a reset control signal RE1 and be turned on or off under the control of the reset control signal RE1. The reset signal Vinit may be input to the N3 node through the third reset transistor T7, to reset the first electrode of the drive transistor T3, the second electrode plate C22 of the second capacitor C2, and the first electrode ANO of the light-emitting device LD, thereby eliminating the influence of the signal from the previous frame of image.

In some embodiments of the present disclosure, at least one of the transistors in the pixel circuit may be an oxide transistor, that is, a material of an active part of the transistor may be a crystalline oxide semiconductor or an amorphous oxide semiconductor. For example, the material of the active part of the transistor may be an oxide of at least one metal among zinc (Zn), indium (In), gallium (Ga), tin (Sn), and titanium (Ti); or may also be a mixture of at least one metal and/or an oxide of at least one metal from zinc (Zn), indium (In), gallium (Ga), tin (Sn), and titanium (Ti). The oxide semiconductor may include a metal oxide such as indium tin oxide (ITO), indium gallium zinc oxide (IGZO), zinc oxide (ZnO), indium zinc oxide (IZnO), zinc gallium oxide (ZIO), indium oxide (InO), titanium oxide (TiO), indium zinc tin oxide (IZTO), zinc tin oxide (ZTO) and the like within the spirit and scope of the present disclosure.

Correspondingly, the transistor may be an N-type transistor. As shown in FIG. 2, if each transistor may be an N-type transistor, a first electrode of each transistor is a source and a second electrode thereof is a drain; the transistor turns on when the gate receives a high level and turns off when the gate receives a low level. For example, as shown in FIG. 2, the drive transistor T3, the data control transistor T6, the write transistor T4, the first reset transistor T1, the second reset transistor T2, the third reset transistor T7, and the light-emitting control transistor T5 are all metal oxide transistors, that is, the transistors in the pixel circuit are all metal oxide transistors to reduce leakage current. Certainly, it is also possible that only some transistors are metal oxide transistors.

A driving method for the pixel circuit will be described below based on the structure of the pixel circuit of the above embodiments.

As shown in FIGS. 2 and 3, the driving method for the pixel circuit according to embodiments of the present disclosure may include:

In a compensation stage t2, the data control circuit CU is turned off and the light-emitting control circuit EU is turned on, to write a threshold voltage of the drive transistor T3 into the energy-storage circuit RU.

Different voltages may be input to the gate and the first electrode of the drive transistor T3, to turn on the drive transistor T3. When the light-emitting control circuit EU is turned on, a voltage at the first electrode of the drive transistor T3 gradually increases, and writing of the threshold voltage of the drive transistor T3 into the energy-storage circuit RU is started. The compensation stage is to start writing the threshold voltage to the energy-storage circuit RU, but is not limited to completing the writing of the threshold voltage.

In a writing stage t3, the write circuit DU and the light-emitting control circuit EU are turned on, and the data control circuit CU is turned off. The data signal Data is written into the energy-storage circuit RU through the write circuit DU, and the threshold voltage of the drive transistor T3 is written into the energy-storage circuit RU.

The data signal Data is written to the energy-storage circuit RU through the write circuit DU, at which time the data control circuit CU remains turned off, preventing the data signal Data from being written to the gate of the drive transistor T3. Meanwhile, when the voltage at the first electrode of the drive transistor T3 reaches a difference between a voltage at its gate and the threshold voltage, the drive transistor T3 is turned off, so that the threshold voltage of the drive transistor T3 may be written into the energy-storage circuit RU. That is, the writing of the threshold voltage and the writing of the data signal Data may be performed simultaneously.

In a light emitting stage t4, the light-emitting control circuit EU and the data control circuit CU are turned on, while the write circuit DU is turned off; a voltage difference between the gate and the first electrode of the drive transistor T3 is controlled by the energy-storage circuit RU to cause the light-emitting device LD to emit light.

The voltage difference between the gate and the first electrode of the drive transistor T3 is stabilized by the energy-storage circuit RU, in which process the data signal Data of the gate will not interfere with the voltage at the first electrode.

Further, as shown in FIGS. 2 and 3, in some embodiments of the present disclosure, the driving method may also include:

In a reset stage t1, the first reset transistor T1, the second reset transistor T2, and the third reset transistor T7 are turned on, while the write circuit DU, the data control circuit CU, and the light-emitting control circuit EU are turned off. By the reference signal Vref, the gate of the drive transistor T3 is reset, and the second electrode plate C12 of the first capacitor C1 and the first electrode plate C21 of the second capacitor C2 are also reset. By the reset signal Vinit, the first electrode of the drive transistor T3 and the second electrode plate C22 of the second capacitor C2 are reset. Meanwhile, a voltage difference between the reset signal Vinit and the reference signal Vref may turn on the drive transistor T3.

For the pixel circuit and the driving method therefor according to the embodiments of the present disclosure, the data control circuit CU is provided between the gate and the first electrode of the drive transistor T3, and the writing of the data signal Data may be divided into two stages. The first stage is the writing stage t3, during which the data signal Data is stored separately through the energy-storage circuit RU, and the data control circuit CU is turned off, so that the data signal Data is not directly written into the gate of the drive transistor T3. The second stage is the light emitting stage t4, during which the data control circuit CU is turned on, and the energy-storage circuit RU is used to apply the data signal Data to the gate of the drive transistor T3. In the compensation stage t2, the threshold voltage of the drive transistor T3 (independent of the storage of the data signal Data) may also be written into the energy-storage circuit RU.

The energy-storage circuit RU does not interfere with the storage of the threshold voltage when storing the data signal Data. In the light emitting stage t4, the energy-storage circuit RU may ensure stable differential voltage between the data signal Data and the first electrode of the drive transistor T3, which may prevent significant differences between actual brightness and design brightness of the light-emitting device LD due to different degrees of interference from the data signal Data, so as to improve the image quality.

Taking a pixel circuit (all transistors are N-type metal oxide transistors) according to the embodiment in FIG. 2 as an example, the driving method for the pixel circuit will be illustrated below.

In the reset stage t1, the reference control signal RE2 received by the gates of the first reset transistor T1 and the second reset transistor T2 is at a high level, and the first reset transistor T1 and the second reset transistor T2 are turned on; the reference signal Vref resets the N1 and N4 nodes, and a voltage of the reference signal Vref may be 2.5V; the reset control signal RE1 received by the gate of the third reset transistor T7 is at a high level, and the third reset transistor T7 is turned on; the reset signal Vinit resets the N3 node, and a voltage of the reset signal Vinit may be 1.5V. At this time, the gate and the first electrode of the drive transistor T3 have a voltage difference and are turned on.

Meanwhile, the light-emitting control signal EM received by the gate of the light-emitting control transistor T5 is at a low level, causing the light-emitting control transistor T5 to turn off; the scanning signal Gate received by the gate of the write transistor T4 is at a low level, causing the write transistor T4 to turn off; the data control signal DC received by the gate of the data control transistor T6 is at a low level, causing the data control transistor T6 to turn off.

The reset of N1 and N4 nodes and the reset of N3 node may be carried out in stages; for example, the reference control signal RE2 changes from a low level to a high level, and the reset control signal RE1 then changes from a low level to a high level; certainly, both may also be carried out simultaneously.

In the compensation stage t2, the light-emitting control signal EM received by the gate of the light-emitting control transistor T5 is at a high level; the light-emitting control transistor T5 is turned on; a voltage at the N2 node is a voltage of the first power signal VDD; and due to the conduction of the drive transistor T3, a voltage at the N3 node gradually increases. The voltage of the first power signal VDD may be 11.5V.

Meanwhile, the reference control signal RE2 is at a high level, and the first reset transistor T1 and the second reset transistor T2 are turned on; the reset control signal RE1 is at a low level, and the third reset transistor T7 is turned off; the data control signal DC is at a low level, and the data control transistor T6 is turned off; the scanning signal Gate is at a low level, and the write transistor T4 is turned off.

In the writing stage t3, the scanning signal Gate is at a high level, and the write transistor T4 is turned on; the data signal Data is written to the N5 node through the write transistor T4, i.e., stored in the first capacitor C1; the data control signal DC is at a low level, and the data control transistor T6 is turned off.

Meanwhile, the light-emitting control signal EM may continue to be at a high level, and the light-emitting control transistor T5 is turned on; the voltage at the N3 node gradually increases until it reaches Vref-Vth, causing the differential voltage between the gate and the first electrode of the drive transistor T3 to be equal to the threshold voltage, i.e., a gate-source voltage difference Vgs=Vth. At this time, drive transistor T3 is turned off; and Vth is the threshold voltage of the drive transistor T3. Thus, the threshold voltage Vth is written into the N3 node and stored in the second capacitor C2. That is, the writing of the threshold voltage starts in the compensation stage t2 and is completed in the writing stage t3; the writing of the threshold voltage lasts from the compensation stage t2 to the writing stage t3. The light-emitting control signal EM may last until the drive transistor T3 is turned off, that is, until the writing of the threshold voltage is completed; for example, the light-emitting control signal EM may last until the scanning signal Gate is turned off, that is, until the writing of the data signal Data is completed.

In addition, the reference control signal RE2 is at a low level, and the first reset transistor T1 and the second reset transistor T2 are turned off; the reset control signal RE1 is at a low level, and the third reset transistor T7 is turned off; the data control signal DC is at a low level, and the data control transistor T6 is turned off.

In the light emitting stage t4, the light-emitting control signal EM is at a high level, and the light-emitting control transistor T5 is turned on; the data control signal DC is at a high level, and the data control transistor T6 is turned on; the reference control signal RE2 is at a low level, and the first reset transistor T1 and the second reset transistor T2 are turned off; the reset control signal RE1 is at a low level, and the third reset transistor T7 is turned off; the scanning signal Gate is at a low level, and the write transistor T4 is turned off; under the action of the first capacitor C1, the data signal Data starts to be written at the N1 node. At this time, a voltage at the N1 node is the voltage at the gate of the drive transistor T3, Vg=Vdata+Vd+VSS - (Vref-Vth); the voltage at the N3 node is the voltage at the first electrode of the drive transistor T3, Vs=Vld+VSS; the gate-source voltage difference of the drive transistor T3 is Vgs=Vdata-Vref+Vth. Vld is a voltage of the light-emitting device LD, VSS is a voltage of the second power signal VSS input to the second electrode CAT of the light-emitting device LD, and Vdata is a voltage of the data signal Data.

The drive transistor T3 outputs a current that satisfies the following formula:

$$I = (\mu WCox/2L)(Vgs - Vth)^2;$$

I is an output current of the drive transistor T3; $\mu$ represents carrier mobility; Cox is gate capacitance per unit area; W is a width of a channel of the drive transistor T3; and L is a length of the channel of the drive transistor T3.

According to the above formula for the output current of the drive transistor T3, the gate-source voltage difference Vgs of the drive transistor T3 in the above pixel circuit may be substituted into the above formula to obtain: the output current I of the drive transistor I = $(\mu WCox/2L)(Vdata - Vref)^2$. It may be seen that the output current of the pixel circuit is independent of the threshold voltage Vth of the drive transistor T3, thereby eliminating influence of the threshold voltage of the drive transistor T3 on its output current, and the control over the output current may be achieved by controlling the voltage Vdata of the data signal Data, in order to control brightness of the light-emitting device LD.

Based on the above pixel circuit, the second capacitor C2 is used to store the threshold voltage Vth, and its capacitance affects the speed and effect of compensation of the threshold voltage Vth; the first capacitor C1 functions to store the voltage of the data signal Data, and its capacitance affects the speed of writing this voltage. Meanwhile, in the light emitting stage t4, a total capacitance between the gate and the first electrode of the drive transistor T3 is a capacitance of the first capacitor C1 and the second capacitor C2 connected in series.

After tests and analysis, in order to meet the needs of the circuit, the capacitance of the second capacitor C2 may be made not less than that of the first capacitor C1. Further, the capacitance of the second capacitor C2 may be made larger than that of the first capacitor C1, and a ratio of the first capacitor C1 to the second capacitor C2 may be greater than 1 and less than 1.5.

It should be noted that although the various steps of the driving method in the present disclosure are described in a specific order in the accompanying drawings, this does not require or imply that these steps must be executed in that specific order, or that all the steps shown must be executed to achieve the desired result. Additionally or alternatively, some steps may be omitted; a plurality of steps may be combined into a single step for execution; and/or a single step may be decomposed into a plurality of steps for execution.

Based on the pixel circuit according to any of the above embodiments, the structure of the display panel of the present disclosure will be described below.

As shown in FIG. 4, the drive backplane BP may include a substrate SU and a drive circuit on a side of the substrate SU. The drive circuit includes a pixel circuit and a peripheral circuit, and the pixel circuit may have the structure according to any of the embodiments described above.

The drive backplane BP may also include a semiconductor layer SE disposed on one side of the substrate SU. The active part of each transistor in the pixel circuit is on the semiconductor layer SE, that is, the active parts of various transistors are arranged on the same layer. The light-emitting device LD is located on a side of the semiconductor layer SE away from the substrate SU, and the first electrode ANO of one light-emitting device LD may be connected to the first electrode of the drive transistor T3 of one pixel circuit.

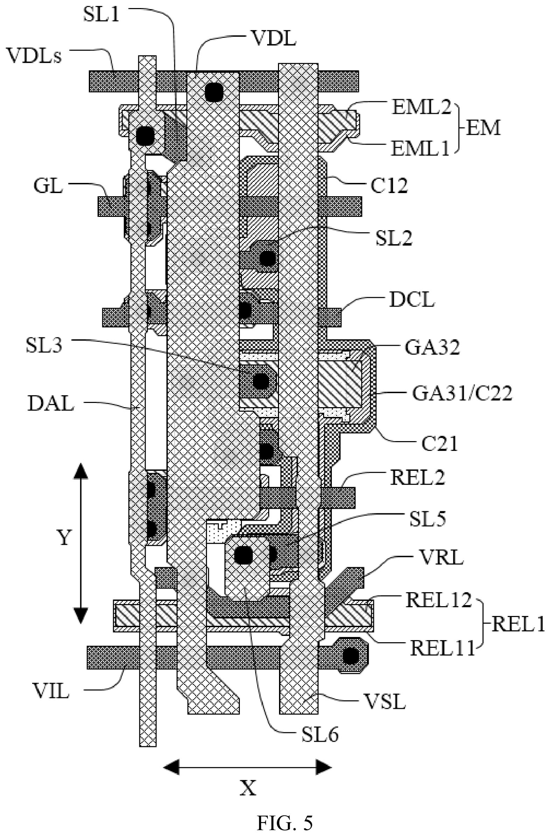

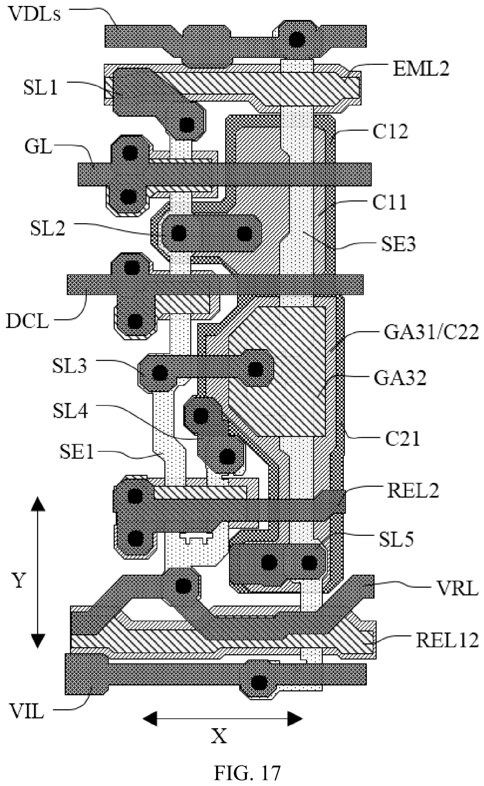

As shown in FIGS. 5-7 and 16-18, in order to facilitate signal transmission, in some embodiments of the present disclosure, the display panel may further include a light-emitting control line EML, a first reset control line REL1, a second reset control line REL2, a scanning line GL, a data control line DCL, a first reset line VRL, and a second reset line VIL.

The light-emitting control line EML may extend along the row direction X and overlap with an active part ACT5 of the light-emitting control transistor T5, and be used to transmit the light-emitting control signal EM. There are a plurality of light-emitting control lines EML spaced apart along the column direction Y, and the pixel circuits in a same row are connected to one light-emitting control line EML.

The first reset control line REL1 extends along the row direction X and overlaps with an active part ACT7 of the third reset transistor T7, and is used to transmit the reset control signal RE1. There are a plurality of first reset control lines REL1 spaced apart along the column direction Y, and the pixel circuits in a same row are connected to one first reset control line REL1.

The second reset control line REL2 may extend along the row direction X and be connected to the gate of the first reset transistor T1 and the gate of the second reset transistor T2, and be used to transmit the reference control signal RE2. There are a plurality of second reset control lines REL2 spaced apart along the column direction Y, and the pixel circuits in a same row are connected to one second reset control line REL2.

The scanning line GL may extend along the row direction X and be connected to the gate of the write transistor T4, and be used to transmit the scanning signal Gate. There are a plurality of scanning lines GL spaced apart along the column direction Y, and the pixel circuits in a same row are connected to one scanning line GL.

The data control line DCL may extend along the row direction X and be connected to the gate of the data control transistor T6, and be used to transmit the data control signal DC. There are a plurality of data control lines DCL spaced apart along the column direction Y, and the pixel circuits in a same row are connected to one data control line DCL.

The first reset line VRL may extend along the row direction X and be connected to the first electrode of the first reset transistor T1 and the first electrode of the second reset transistor T2, and be used to transmit the reference signal Vref. There are a plurality of first reset lines VRL spaced apart along the column direction Y, and the pixel circuits in a same row are connected to one first reset line VRL.

The second reset line VIL may extend along the row direction X and be connected to the first electrode of the third reset transistor T7, and be used to transmit the reset signal Vinit. There are a plurality of second reset lines VIL spaced apart along the column direction Y, and the pixel circuits in a same row are connected to one second reset line VIL.

Further, as shown in FIGS. 5-7 and 16-18, in some embodiments of the present disclosure, orthographic projections of the light-emitting control line EML, the scanning line GL, the data control line DCL, the first reset line VRL, the second reset control line REL2, the first reset control line REL1, and the second reset line VIL on the substrate SU may be sequentially spaced apart along the column direction Y.

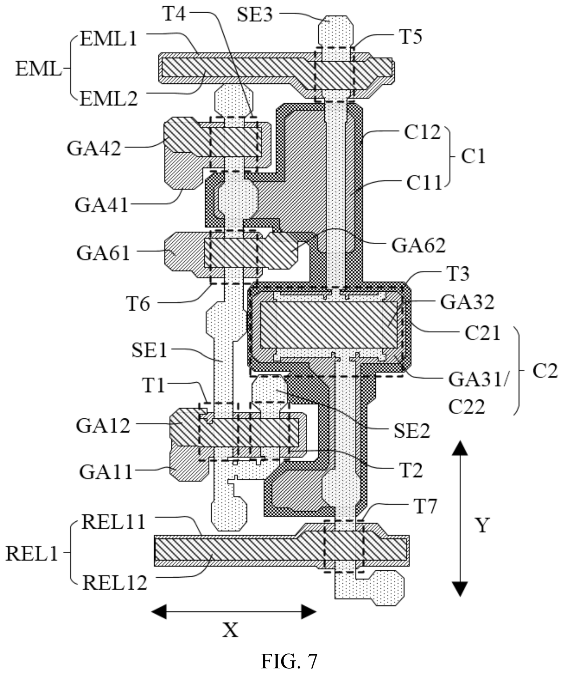

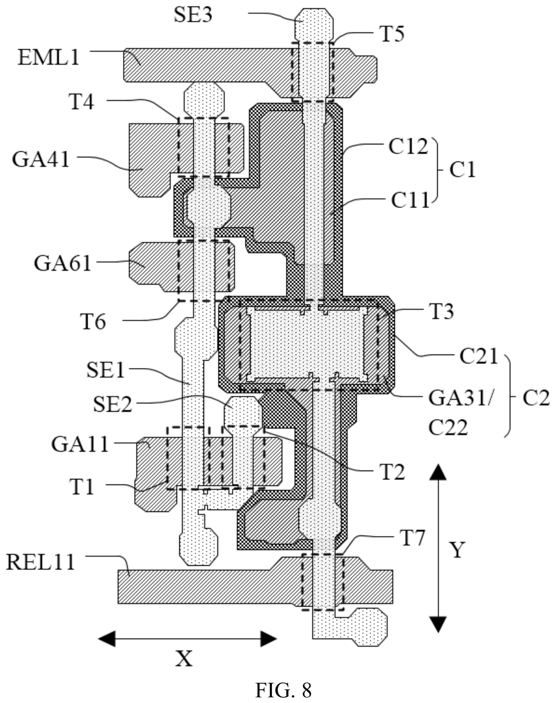

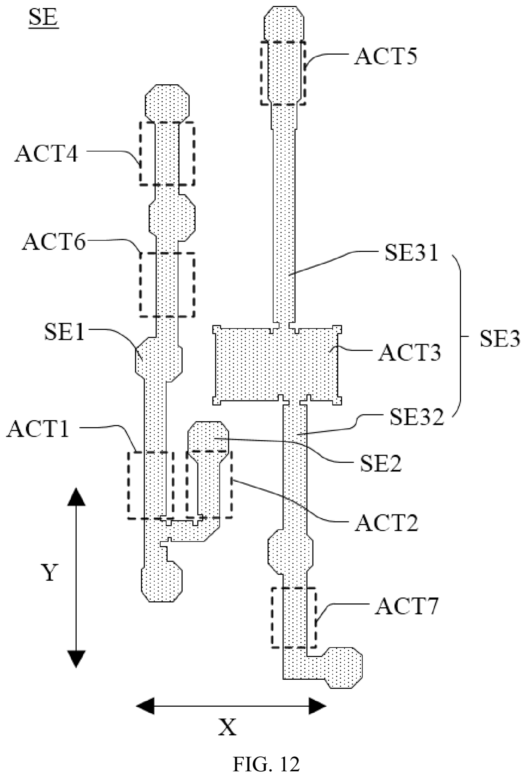

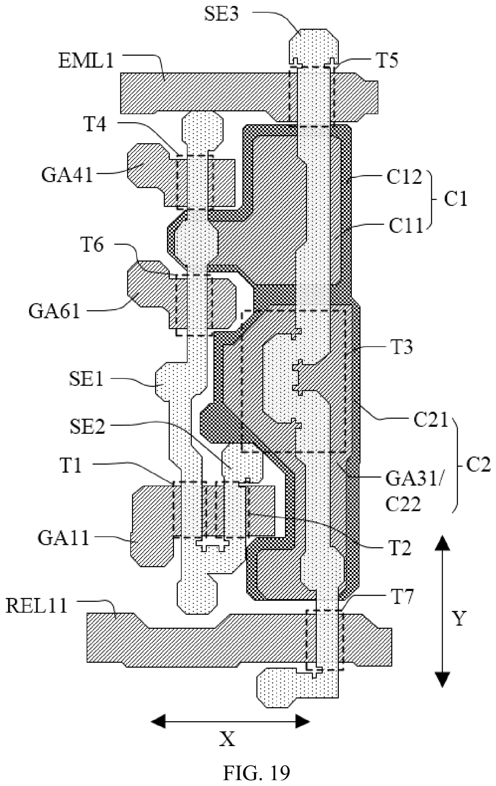

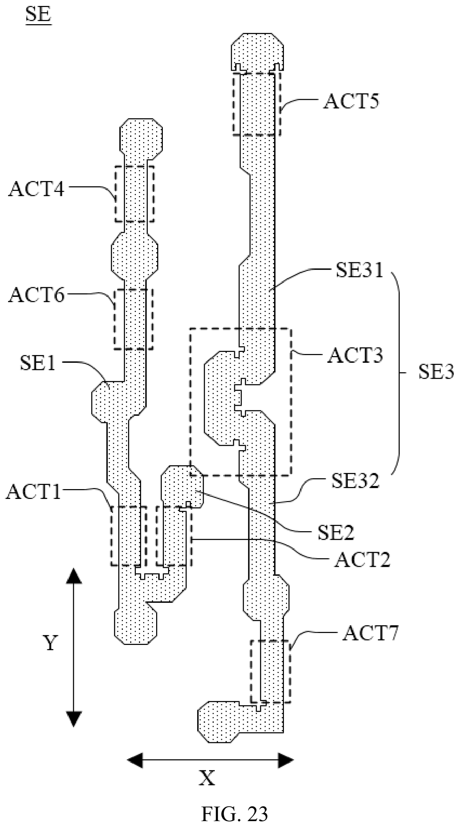

As shown in FIGS. 7, 8, 12, 18, 19, and 23, an orthographic projection of the active part ACT3 of the drive transistor T3 on the substrate SU is located between the orthographic projections of the data control line DCL and the second reset control line REL2 on the substrate SU. Orthographic projections of the active part ACT4 of the transistor T4 and the first capacitor C1 on the substrate SU are at least partially located between the orthographic projections of the light-emitting control line EML and the data control line DCL on the substrate SU. Orthographic projections of active parts ACT1 and ACT2 of the first reset transistor T1 and the second reset transistor T2 on the substrate SU are located between the orthographic projections of the active part ACT3 of the drive transistor T3 and the second reset control line REL2 on the substrate SU.

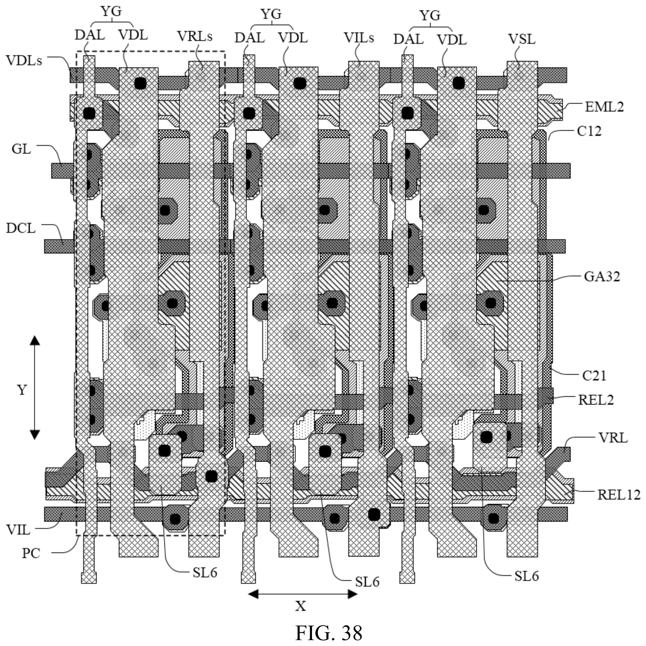

As shown in FIGS. 5, 16, 27, and 38, in order to provide the first power signal VDD for the pixel circuit, in some embodiments of the present disclosure, the display panel further includes a plurality of first power lines VDL, which may be located on a side of the pixel circuit away from the substrate SU. The first power lines VDL may extend along the column direction Y and may be spaced apart along the row direction X. One first power line VDL overlaps with a column of pixel circuits and is connected to the first electrode of the light-emitting control transistor T5 of this column of pixel circuits, so as to provide the first power signal VDD for the pixel circuits.

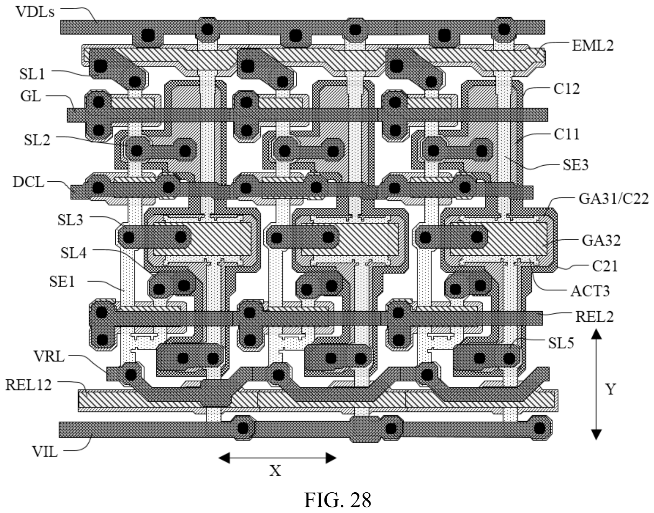

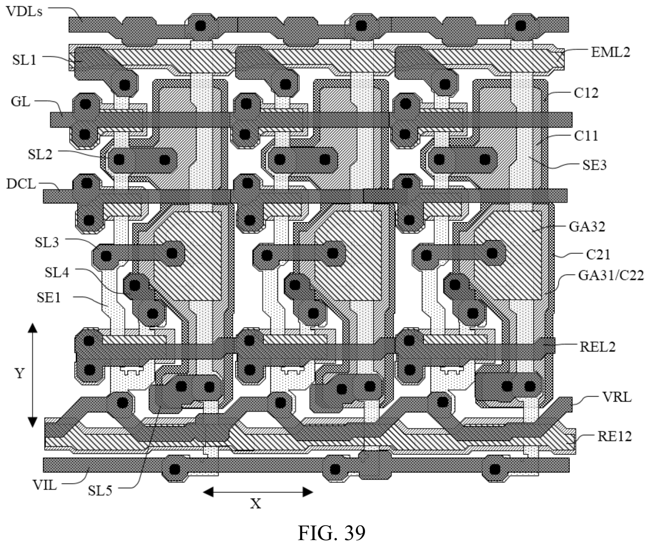

As shown in FIGS. 5, 6, 16, 17, 27, 28, 38, and 39, in order to reduce resistance, a plurality of first auxiliary power lines VDLS may be provided on the side of the pixel circuit away from the substrate SU, with the first power lines VDL located on a side of the first auxiliary power lines VDLS away from the substrate SU. The first auxiliary power lines VDLS may extend along the row direction X and be distributed along the column direction Y. One first auxiliary power line VDLS may be provided between two adjacent rows of pixel circuits; the first auxiliary power line VDLS is connected to the first electrode of the light-emitting control transistor T5 of one row of pixel circuits on one side of the first auxiliary power line. One first power line VDL and each first auxiliary power line VDLS are located on different layers and connected through a contact hole, and overlap with one column of pixel circuits. The first power line VDL may be connected to the pixel circuits through the first auxiliary power line VDLS, and the first power line VDL and the first auxiliary power line VDLS may form a network for transmitting the first power signal VDD in space, which is conducive to reducing the resistance.

As shown in FIGS. 5, 16, 27, and 38, in order to provide the data signal Data for the pixel circuit, the display panel may also include a plurality of data lines DAL, which may be arranged on a side of the first auxiliary power line VDLS away from the substrate SU and may be arranged on the same layer as the first power line VDL. The data lines DAL may extend along the column direction Y and be spaced apart along the row direction X. One data line DAL overlaps with a column of pixel circuits and is connected to the first electrode of the write transistor T4 of this column of pixel circuits, so as to transmit the data signal Data.

As shown in FIGS. 5, 16, 27, and 38, in some embodiments of the present disclosure, the display panel further includes a plurality of second power lines VSL, which may be arranged on the side of the first auxiliary power line VDLS away from the substrate SU. The second power lines VSL extend along the column direction Y and are spaced apart along the row direction X. One second power line VSL may overlap with one column of pixel circuits, but the number of second power lines VSL may be less than the number of columns of pixel circuits, that is, only some columns of pixel circuits may overlap with the second power lines VSL. The second power lines VSL are used to transmit the second power signal VSS.

The peripheral area WA of the display panel may also be provided with a first power bus and a second power bus. The first power line VDL may extend to the peripheral area WA and be connected to the first power bus. The first power signal VDD may be input to the first power line VDL through the first power bus. The second power line VSL may extend to the peripheral area WA and be connected to the second power bus. The second power signal VSS may be input to the second power line VSL through the second power bus. Individual light-emitting devices LD may share one second electrode CAT, i.e., the second electrode CAT may be of a continuous layer structure and may be connected to the second power bus in the peripheral area WA to receive the second power signal VSS. By using the second power line VSL, the resistance may be reduced and a voltage drop of the second power signal VSS may be minimized.

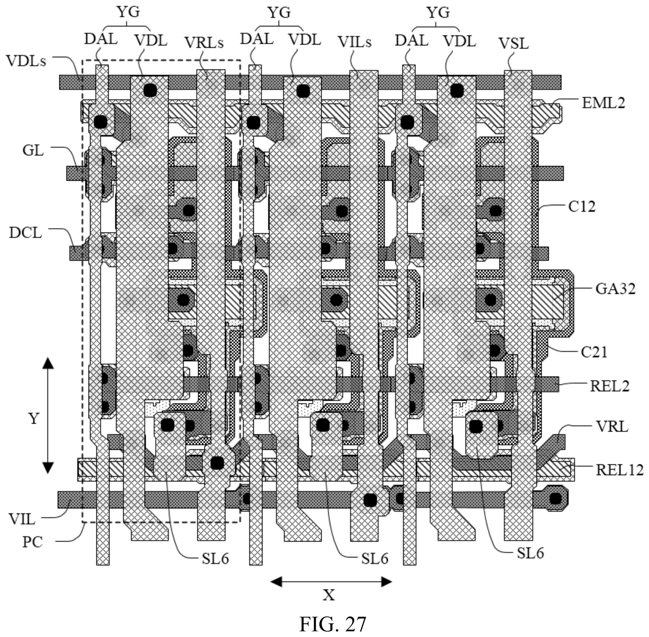

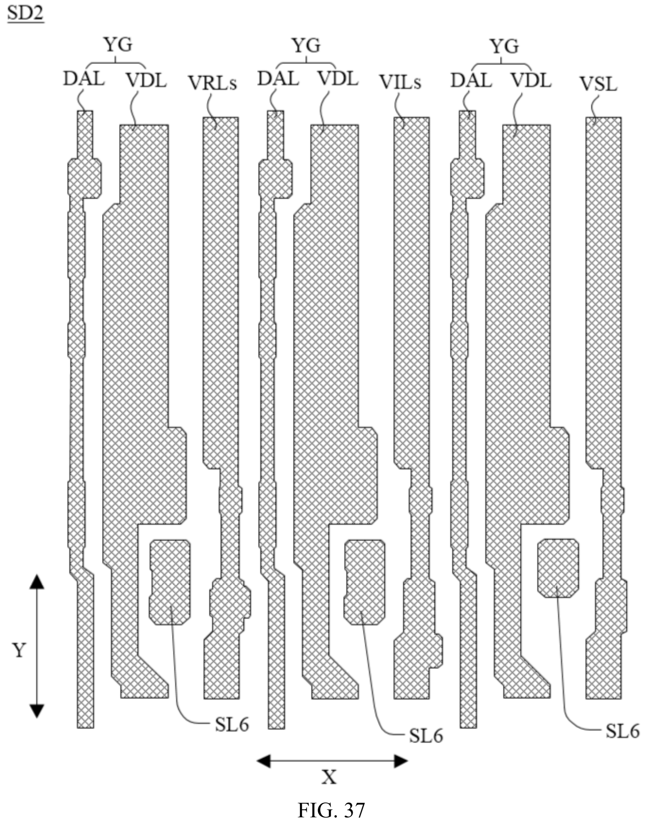

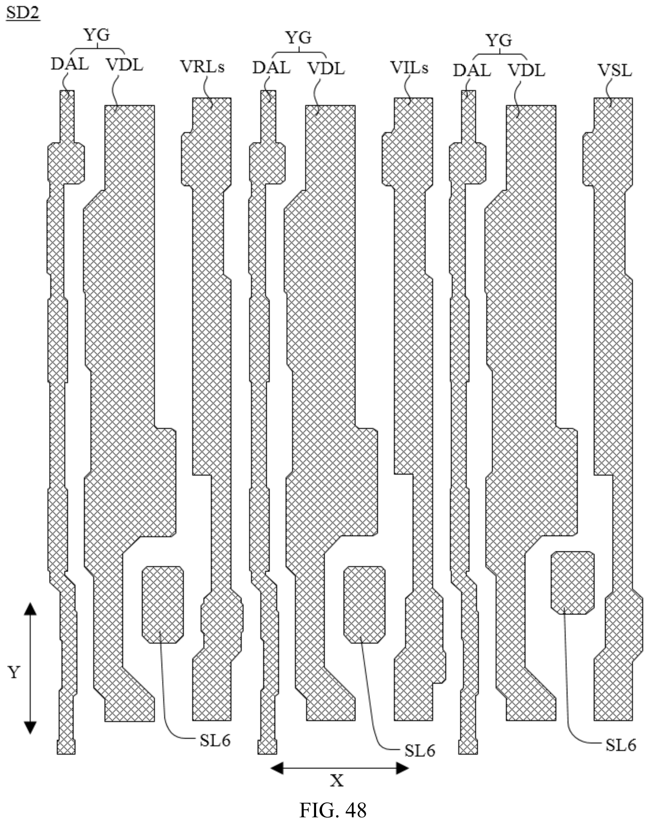

As shown in FIGS. 27, 37, 38, and 48, in some embodiments of the present disclosure, the display panel further includes a plurality of first auxiliary reset lines VRLs and a plurality of second auxiliary reset lines VILs.

The first auxiliary reset lines VRLs and the second auxiliary reset lines VILs may be provided on the side of the first auxiliary power line VDLS away from the substrate SU, and the first auxiliary reset lines VRLs and the second auxiliary reset lines VILs may be arranged on the same layer. Each first auxiliary reset line VRLs and each second auxiliary reset line VILs extend along the column direction Y and are spaced apart along the row direction X.

The first auxiliary reset line VRLs and the first reset line VRL may be located in different layers and may be connected through a contact hole. The first auxiliary reset line VRLs and the first reset line VRL may form a network for transmitting the reference signal Vref in space, which is beneficial for reducing resistance. The second auxiliary reset line VILs and the second reset line VIL may be located in different layers and may be connected through a contact hole. The second auxiliary reset line VILs and the second reset line VIL may form a network for transmitting the reset signal Vinit in space, which is beneficial for reducing resistance.

One first auxiliary reset line VRLs may overlap with one column of pixel circuits, and one second auxiliary reset line VILs may overlap with one column of pixel circuits. However, the number of first auxiliary reset lines VRLs and the number of second auxiliary reset lines VILs are both less than the number of columns of pixel circuits, that is, only some columns of pixel circuits may overlap with the first auxiliary reset lines VRLs and the second auxiliary reset lines VILs.

In some embodiments of the present disclosure, as shown in FIGS. 27, 37, 38, and 48, the data line DAL and the first power line VDL connected to a same column of pixel circuits PC may be defined as one column line group YG, that is, each column of pixel circuits PC may be connected to one column line group YG. Meanwhile, one of the second power line VSL, the first auxiliary reset line VRLs, and the second auxiliary reset line VILs may be provided between two adjacent column line groups YG, that is, the second power line VSL, the first auxiliary reset line VRLs, and the second auxiliary reset line VILs are distributed in the space between the column line groups YG. Meanwhile, two of the second power line VSL, the first auxiliary reset line VRLs, and the second auxiliary reset line VILs are provided on both sides of a same column line group YG. As a result, space may be fully utilized to make the distribution of lines in the column direction Y more uniform.

Further, in one first power line VDL and one pixel circuit overlapping therewith, the first power line VDL overlaps with the active part ACT4 of the write transistor T4, the active part ACT4 of the data control transistor T6, the active part ACT1 of the first reset transistor T1, and the active part ACT2 of the second reset transistor T2. The second power line VSL overlaps with the active part ACT5 of the light-emitting control transistor T5, the active part ACT3 of the drive transistor T3, and the active part ACT7 of the third reset transistor T7. Since the first power signal VDD, the second power signal VSS, the reference signal Vref, and the reset signal Vinit are all constant voltage signals, they may play a shielding role for the transistors blocked by the first power line VDL and the second power line VSL, and avoid interference from voltage changes of the first electrode ANO of the light-emitting device LD.

In some embodiments of the present disclosure, the light-emitting control line EML, the scanning line GL, the data control line DCL, the second reset control line REL2, the first reset line VRL, and the first reset control line REL1 connected to a same row of pixel circuits may be defined as one row line group, that is, each row of pixel circuits PC is connected to one row line group. Meanwhile, there may be one first auxiliary power line VDLs and one second reset line VIL between two adjacent row line groups. One row line group is located between one first auxiliary power line VDLs and one second reset line VIL.

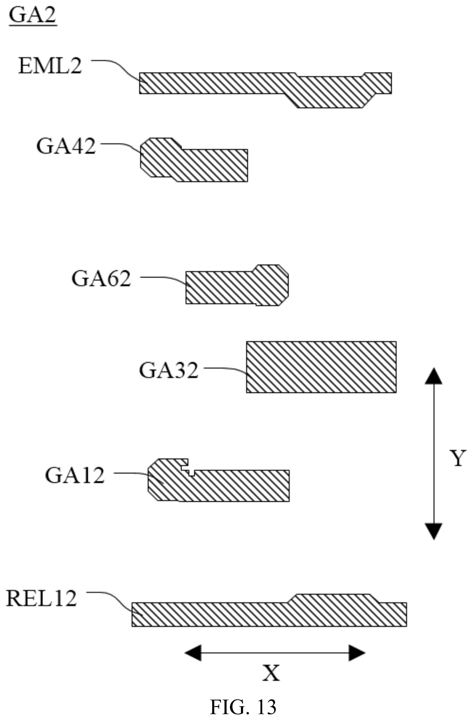

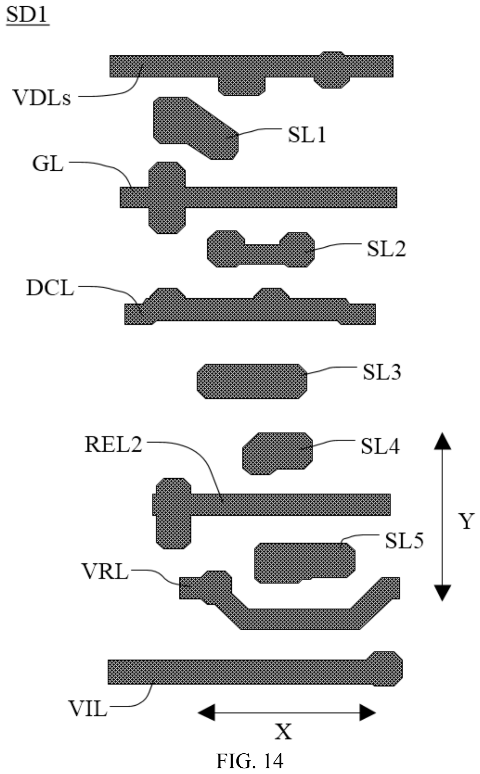

As shown in FIGS. 13 and 14, in order to reduce resistance, the light-emitting control line EML and the first reset control line REL1 may be made as a double-layer structure. For example, the light-emitting control line EML may include a first light-emitting control subline EML1 and a second light-emitting control subline EML2 arranged in a direction away from the substrate SU; the first light-emitting control subline EML1 and the second light-emitting control subline EML2 extend along the row direction X and are connected. Orthographic projections of the first light-emitting control subline EML1 and the second light-emitting control subline EML2 on the substrate SU at least partially overlap.

The first reset control line REL1 may include a first reset control subline REL11 and a second reset control subline REL12 arranged in the direction away from the substrate SU; the first reset control subline REL11 and the second reset control subline REL12 extend along the row direction X and are connected. Orthographic projections of the first reset control subline REL11 and the second reset control subline REL12 on the substrate SU at least partially overlap.

In order to simplify the structure and process, one of the first electrode plate C11 and the second electrode plate C12 of the first capacitor C1 may be arranged on a same layer as one of the first electrode plate C21 and the second electrode plate C22 of the second capacitor C2; and film layers arranged on the same layer may be formed simultaneously by a same patterning process, which is beneficial for simplifying the structure and process. Meanwhile, one of the first capacitor C1 and the second capacitor C2 may overlap with the active part ACT3 of the drive transistor T3, and the electrode plate of the capacitor may be used as the gate of the drive transistor T3, which is beneficial for saving space.

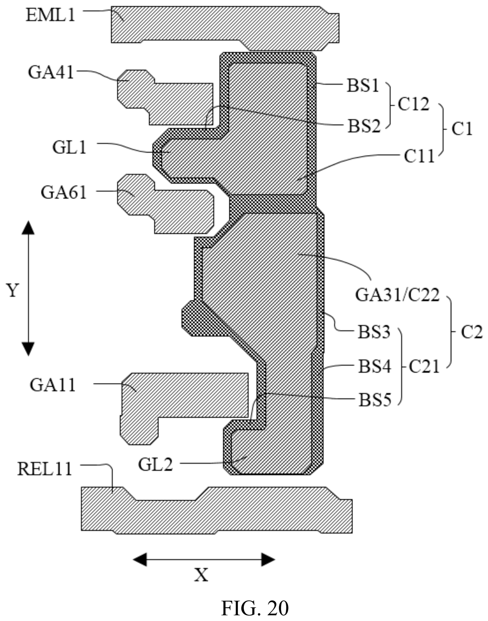

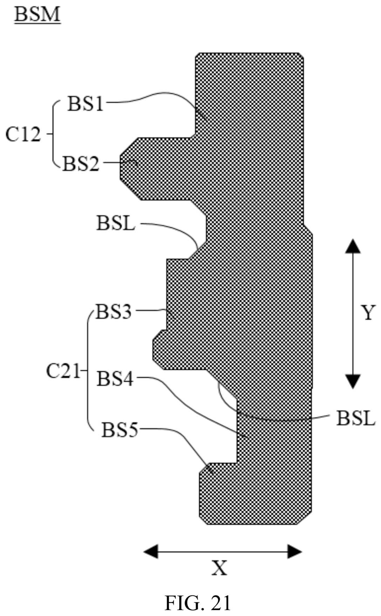

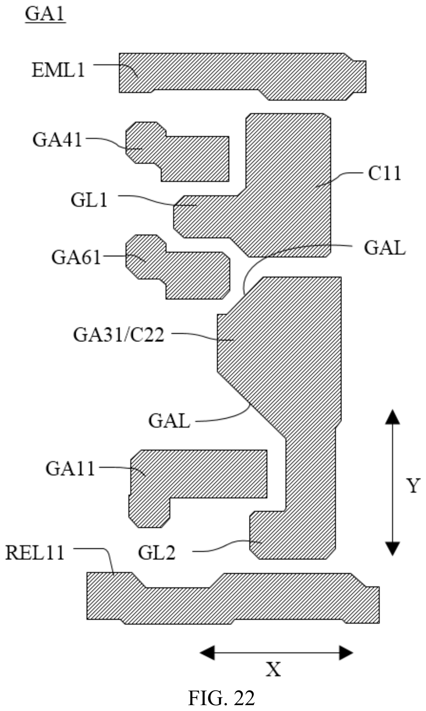

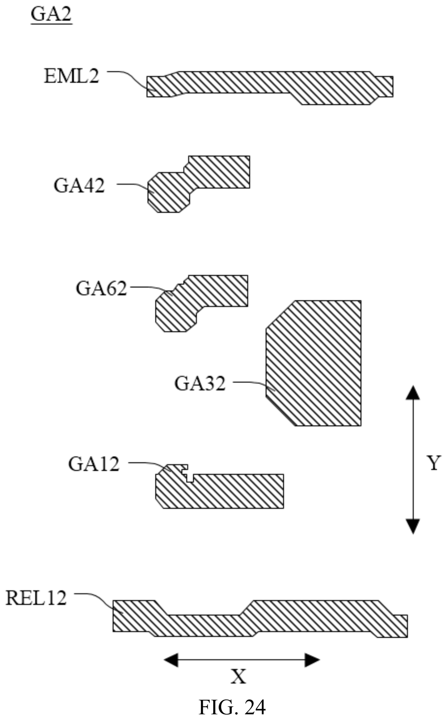

In some embodiments of the present disclosure, as shown in FIGS. 7, 8, 10-14, 18, 19, and 20-24, the first electrode plate C11 of the first capacitor C1 and the second electrode plate C22 of the second capacitor C2 are arranged in a same layer and distributed along the column direction Y; the second electrode plate C12 of the first capacitor C1 and the first electrode plate C21 of the second capacitor C2 are arranged in a same layer and have an integrated structure, and certainly, they may also be on the same layer but have a split structure; the first electrode plate C21 and the second electrode plate C22 of the second capacitor C2 overlap with the active part ACT3 of the drive transistor T3.

By changing a width-to-length ratio of the drive transistor T3, an on-state current (Ion) may be increased or a subthreshold swing (S.S) may be lowered. For example:

The first electrode, the active part ACT3, and the second electrode of the drive transistor T3 may be distributed along the column direction Y. In a first embodiment of the present disclosure, a width of the active part ACT3 of the drive transistor T3 along the row direction X may be increased to increase a width of a channel region, thereby increasing the width-to-length ratio and improving the on-state current. For example, the width of the channel region of the active part ACT3 of the drive transistor T3 in the row direction X may be made not less than 6 μm and not greater than 20 μm, and the width may be 6 μm, 10 μm, 16 μm, or 20 μm. At this time, the width-to-length ratio of the drive transistor T3 may be 16/6, 20/6 or the like.

In a second embodiment of the present disclosure, the active part ACT3 of the drive transistor T3 may be bent to increase a length of the channel region, thereby reducing the width-to-length ratio and lowering the subthreshold swing. For example, the length of the channel region of the active part ACT3 of the drive transistor T3 in its extension direction is not less than 20 μm and not greater than 30 μm, and the length may be 20 μm, 25 μm, or 30 μm. At this time, the width-to-length ratio of the drive transistor T3 may be 4/25, 4/30 or the like.

Through the above two embodiments, the width-to-length ratio of the drive transistor T3 may be limited to no greater than 20/6 and no less than 4/30.

The channel region of each transistor herein is a region where its active part overlaps with its gate.

The setting of the width-to-length ratio of the drive transistor T3 may be achieved by designing the pattern of the active part ACT3 of the drive transistor T3. A pattern of a semiconductor layer corresponding to one pixel circuit is taken as example for illustrative explanation below.

As shown in FIGS. 5-9, 12, 16-20, and 23, in some embodiments of the present disclosure, the semiconductor layer SE may include a first semiconductor part SE1, a second semiconductor part SE2, and a third semiconductor part SE3 spaced apart along the row direction X; the second semiconductor part SE2 is located between the first semiconductor part SE1 and the third semiconductor part SE3.

The active parts ACT4, ACT6, and ACT1 of the write transistor T4, the data control transistor T6, and the first reset transistor T1 are all located in the first semiconductor part SE1 and connected in sequence along the column direction Y. The active part ACT2 of the second reset transistor T2 is located in the second semiconductor part SE2. The active part ACT5 of the light-emitting control transistor T5, the active part ACT3 of the drive transistor T3, and the active part ACT7 of the third reset transistor T7 are located in the third semiconductor part SE3 and connected in sequence along the column direction Y. The second semiconductor part SE2 and the third semiconductor part SE3 are connected, thereby connecting the first electrode of the first reset transistor T1 with the first electrode of the second reset transistor T2.

In the first embodiment described above, the third semiconductor part SE3 includes a first semiconductor segment SE31 and a second semiconductor segment SE32 distributed along the column direction Y; the active part ACT3 of the drive transistor T3 is connected between the first semiconductor segment SE31 and the second semiconductor segment SE32. Meanwhile, the width of the active part ACT3 of the drive transistor T3 in the row direction X is greater than the width of the first semiconductor segment SE31 and the width of the second semiconductor segment SE32 in the row direction X. Thus, by increasing a partial width of the third semiconductor part SE3 along the row direction X, the width of the channel of the drive transistor T3 may be increased, and the width-to-length ratio may be increased.

The first semiconductor segment SE31 and the second semiconductor segment SE32 may extend in a straight line along the column direction Y, and the active part ACT3 of the drive transistor T3 may extend towards both sides of the first semiconductor segment SE31 and the second semiconductor segment SE32 in the row direction X, maximizing the width of the channel of the drive transistor T3. Certainly, it may also extend towards only one side. Meanwhile, the active parts ACT3 on both sides of the first semiconductor segment SE31 and the second semiconductor segment SE32 may be symmetrical or asymmetrical. Meanwhile, a contour of the orthographic projection of the active part ACT3 of the drive transistor T3 on the substrate SU may be rectangular; or certainly, it may be elliptical or in other shapes.

In the second embodiment described above, the third semiconductor part SE3 also includes a first semiconductor segment SE31 and a second semiconductor segment SE32 distributed along the column direction Y; the active part ACT3 of the drive transistor T3 is connected between the first semiconductor segment SE31 and the second semiconductor segment SE32. Different from the first embodiment, the active part ACT3 of the drive transistor T3 may be bent along the row direction X towards and/or away from the first semiconductor part SE1, and the bending herein means that the drive transistor T3 extends along a curved or folded trajectory, which may be U-shaped, V-shaped, wavy, etc., and the shape of which will not be specifically limited herein. Therefore, by extending a partial length of the third semiconductor part SE3, the length of the channel of the drive transistor T3 may be increased, and the width-to-length ratio may be reduced.

The first semiconductor segment SE31 and the second semiconductor segment SE32 may extend in a straight line along the column direction Y, and the active part ACT3 of the drive transistor T3 may be bent along the row direction X towards one side of the first semiconductor segment SE31 and the second semiconductor segment SE32 or may be bent towards both sides simultaneously, so as to maximize the length of the channel of the drive transistor T3. Meanwhile, if the active part ACT3 is bent towards both sides, the active parts ACT3 on both sides of the first semiconductor segment SE31 and the second semiconductor segment SE32 may be symmetrical or asymmetrical.

Various film layers of the backplate BP and their patterns will be exemplified below.

As shown in FIGS. 4 and 5, in some embodiments of the present disclosure, the display panel includes a light-shielding layer BSM, a first gate layer GA1, a second gate layer GA2, a first source-drain layer SD1, and a second source-drain layer SD2.

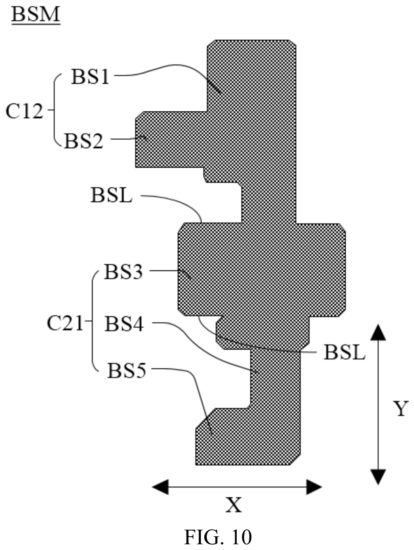

As shown in FIG. 10, the light-shielding layer BSM is located on one side of the substrate SU, and may be made of metal or other conductive and light-shielding materials. The light-shielding layer BSM may include the second electrode plate C12 of the first capacitor C1 and the first electrode plate C21 of the second capacitor C2, that is, the second electrode plate C12 of the first capacitor C1 and the first electrode plate C21 of the second capacitor C2 are arranged on the same layer; and the second electrode plate C12 of the first capacitor C1 and the first electrode plate C21 of the second capacitor C2 may be connected as an integrated structure.

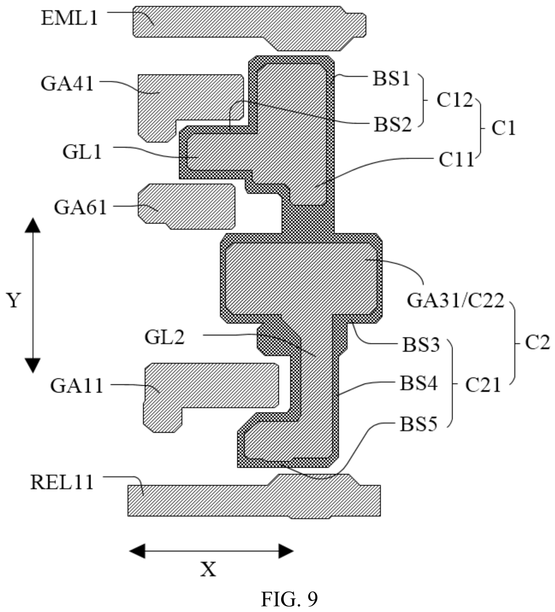

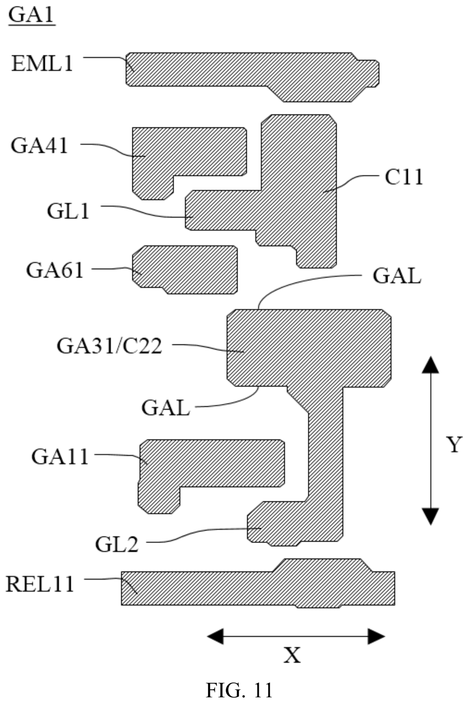

As shown in FIGS. 9 and 11, the first gate layer GA1 may be located on a side of the light-shielding layer BSM away from the substrate SU, and the first gate layer GA1 may include the first electrode plate C11 of the first capacitor C1, the second electrode plate C22 of the second capacitor C2, the first light-emitting control subline EML1, and the first reset control subline REL11. The semiconductor layer SE is disposed on a side of the first gate layer GA1 away from the substrate SU.

As shown in FIGS. 7 and 13, the second gate layer GA2 may be located on the side of the semiconductor layer SE away from the substrate SU, and include the second light-emitting control subline EML2 and the second reset control subline REL12.

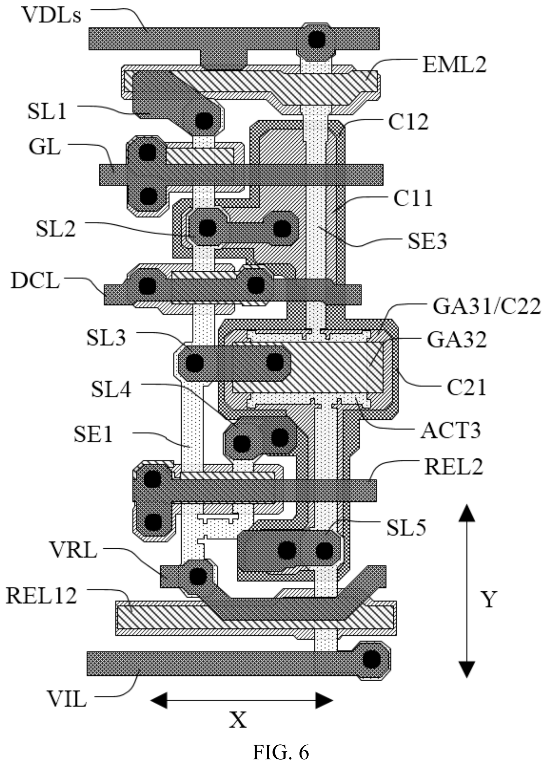

As shown in FIGS. 6 and 14, the first source-drain layer SD1 may be located on a side of the second gate layer GA2 away from the substrate SU, and include the first auxiliary power line VDLs, the scanning line GL, the data control line DCL, the second reset control line REL2, the first reset line VRL, and the second reset line VIL.

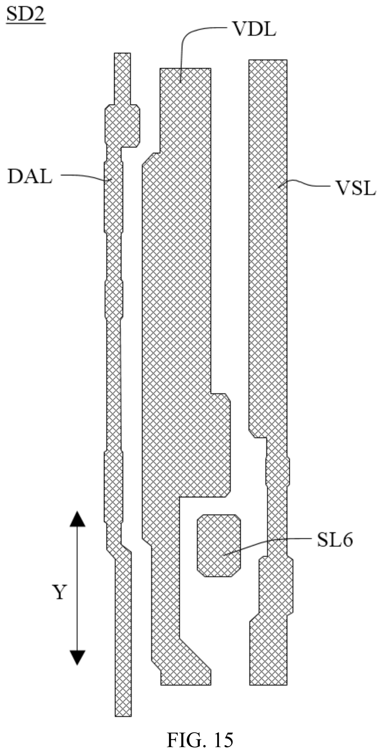

As shown in FIGS. 5 and 15, the second source-drain layer SD2 may be located on a side of the first source-drain layer SD1 away from the substrate SU, and include the data line DAL, the first power line VDL, the second power line VSL, the first auxiliary reset line VRLs, and the second auxiliary reset line VILs.

Further, as shown in FIG. 4, in some embodiments of the present disclosure, the display panel may further include an insulating film layer, including a buffer layer BUF, a first gate insulating layer GI1, a second gate insulating layer GI2, an interlayer dielectric layer ILD, a passivation layer, a first planarization layer PLN1, and a second planarization layer PLN2.

The buffer layer BUF may cover the light-shielding layer BSM; the first gate layer GA1 is disposed on a surface of the buffer layer BUF away from the substrate SU; the first gate insulating layer GI1 covers the first gate layer GA1; the semiconductor layer SE is disposed on a surface of the first gate insulating layer GI1 away from the substrate SU; the second gate insulating layer GI2 covers the semiconductor layer SE; the second gate layer GA2 is disposed on a surface of the second gate insulating layer GI2 away from the substrate SU; the interlayer dielectric layer ILD covers the second gate layer GA2; the first source-drain layer SD1 is disposed on a surface of the interlayer dielectric layer ILD away from the substrate SU; the passivation layer covers the first source-drain layer SD1, and the first planarization layer PLN1 covers the passivation layer. Certainly, the passivation layer may also be omitted, and the first planarization layer PLN1 directly covers the first source-drain layer SD1; the second source-drain layer SD2 is disposed on a surface of the first planarization layer PLN1 away from the substrate SU; the second planarization layer PLN2 covers the second source-drain layer SD2. The first electrode ANO of the light-emitting device LD is disposed on a surface of the second planarization layer PLN2 away from the substrate SU, and may be separated by a pixel define layer PDL. Specifically, the pixel define layer PDL and the first electrode ANO are disposed on the surface of the second planarization layer PLN2 away from the substrate SU; the pixel define layer PDL has a pixel opening that exposes the first electrode ANO, and the light-emitting layer EL is at least partially located within the pixel opening.

Patterns of some film layers will be further explained below.

At least some of the transistors in the pixel circuit may include a gate (bottom gate) located on a side of the active part close to the substrate SU and a gate (top gate) located on a side of the active part away from the substrate SU; and the bottom gate and the top gate of at least some transistors are connected. For example, the bottom gate and the top gate of the first reset transistor T1, the second reset transistor T2, the third reset transistor T7, the write transistor T4, the light-emitting control transistor T5, and the data control transistor T6 are connected; the first electrode of the drive transistor T3 is connected to at least one of the top gate and the bottom gate.

Light-shielding layer BSM

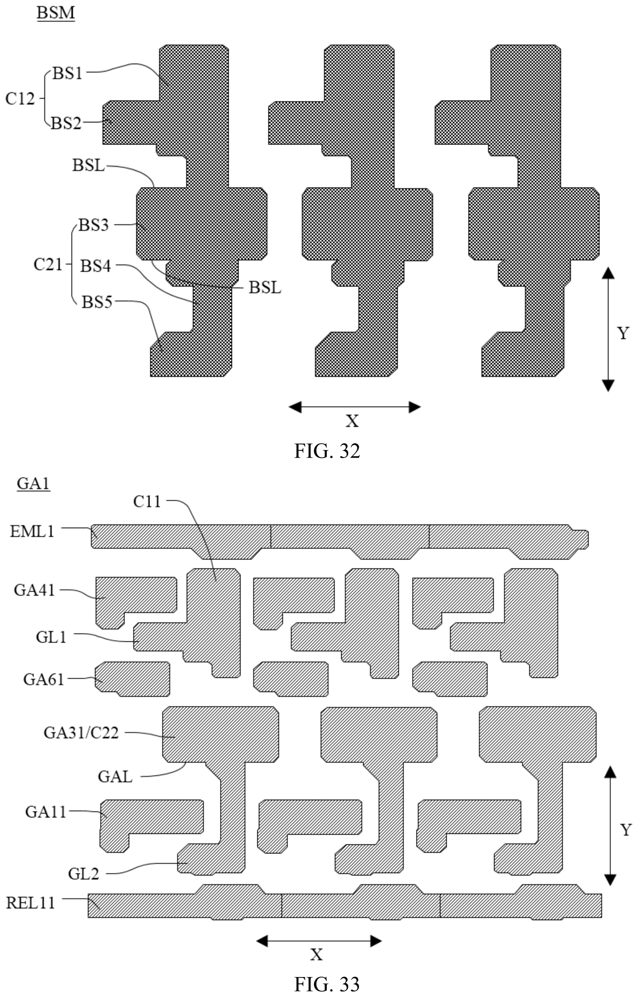

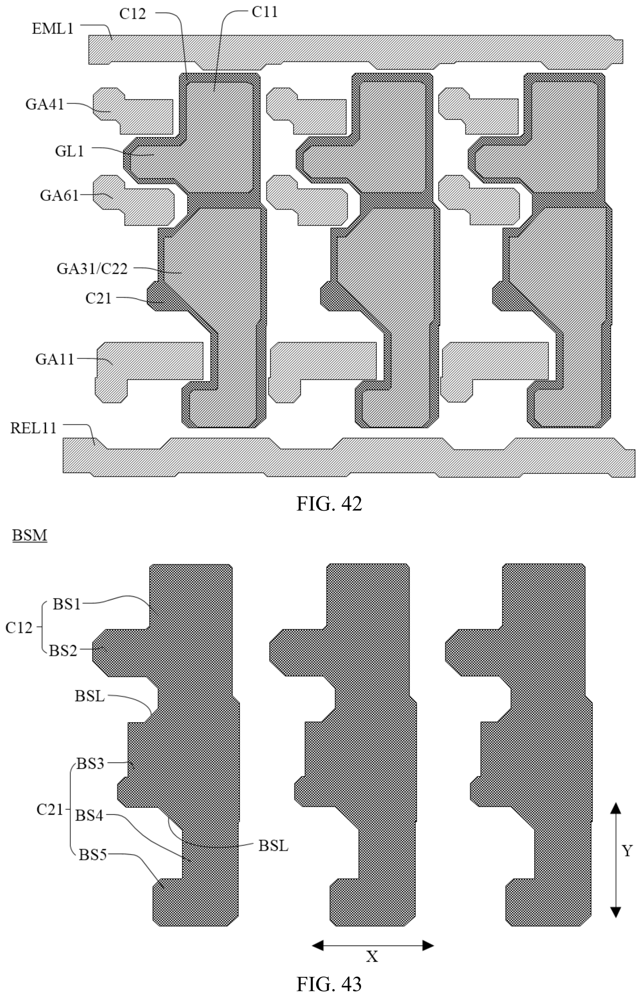

As shown in FIGS. 7-10, 18-21, 32, and 43, in some embodiments of the present disclosure, the light-shielding layer BSM of one pixel circuit includes the second electrode plate C12 of the first capacitor C1 and the first electrode plate C21 of the second capacitor C2, and the second electrode plate C12 and the first electrode plate C21 may be connected as an integrated structure, to achieve the series connection of the first capacitor C1 and the second capacitor C2.

The second electrode plate C12 of the first capacitor C1 has a first shielding body BS1 and a first shielding part BS2 that extends along the row direction X, so as to increase an area of the second electrode plate C12, which facilitates an increase in the capacitance of the first capacitor C1. The first shielding part BS2 overlaps with the first semiconductor part SE1, and an orthographic projection of the first shielding part BS2 on the substrate SU is between the active part ACT4 of the write transistor T4 and the active part ACT6 of the data control transistor T6.

The first electrode plate C21 of the second capacitor C2 may overlap with the active part ACT3 of the drive transistor T3, and the orthographic projection of the active part ACT3 on the substrate SU is located within an orthographic projection of the first electrode plate C21 on the substrate SU. The drive transistor T3 is shielded by the second capacitor C2 to prevent light from shining on the active part ACT3 of the drive transistor T3. The first electrode plate C21 of the second capacitor C2 has a second shielding body BS3 and a second shielding part BS4 that extends along the column direction Y, and the second shielding part BS4 may overlap with the third semiconductor part SE3.

The first electrode plate C21 of the second capacitor C2 may also have a third shielding part BS5 formed by an edge of the second shielding part BS4 extending along the row direction X. An orthographic projection of the third shielding part BS5 on the substrate SU is located between orthographic projections of the first reset line VRL and the second reset control line REL2 on the substrate SU, and between orthographic projections of the first semiconductor part SE1 and the third semiconductor part SE3 on the substrate SU. By the second shielding part BS4 and the third shielding part BS5, an area of the first electrode plate C21 of the second capacitor C2 may be increased, which is beneficial for increasing the capacitance of the second capacitor C2.

As shown in FIGS. 7-10, for the first embodiment mentioned above, the second shielding body BS3 has two shielding side edges BSL extending along the row direction X and distributed along the column direction Y, which may overlap with the active part ACT3 of the drive transistor T3 in the row direction X, thereby shielding the active part ACT3.

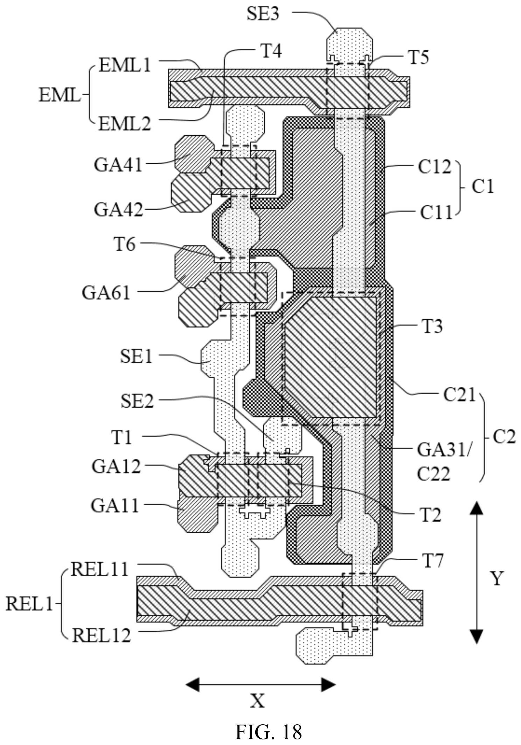

As shown in FIGS. 18-21, for the second embodiment mentioned above, the second shielding body BS3 protrudes towards a direction close to the first semiconductor part SE1, and a protruding part has two shielding side edges BSL distributed along the column direction Y. A distance between the two shielding side edges BSL decreases along the direction close to the first semiconductor part SE1, so that an extension direction of the two shielding side edges BSL intersects with both the row direction X and the column direction Y. The second shielding body BS3 may overlap with the active part ACT3 of the drive transistor T3, thereby shielding the active part ACT3.

First gate layer GA1

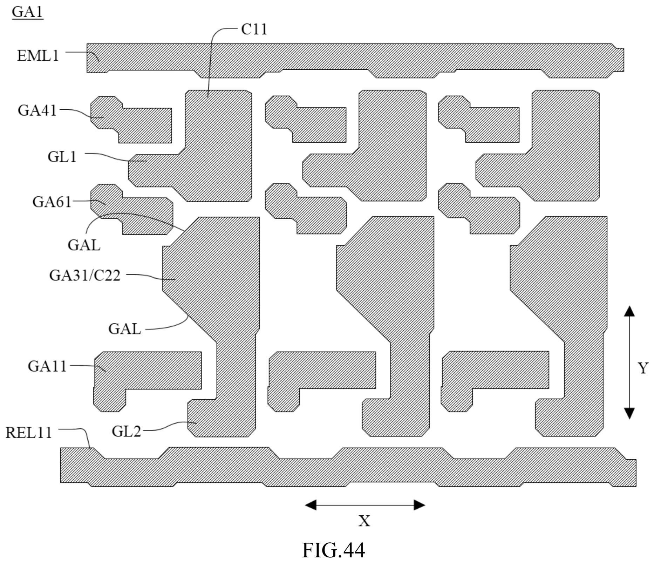

As shown in FIGS. 5-9, 11, 16-20, 22, 33, and 44, in some embodiments of the present disclosure, the first gate layer GA1 may be used to form the gate of at least some of the transistors, and may further include a first gate part GA41, a second gate part GA61, a third gate part GA31, and a fourth gate part GA11; the first light-emitting control subline EML1, the first electrode plate C11 of the first capacitor C1, the second electrode plate C22 of the second capacitor C2, and the first reset control subline REL11 may be sequentially spaced apart along the column direction Y. The first gate part GA41, the second gate part GA61, the third gate part GA31, and the fourth gate part GA11 are distributed along the column direction Y and between the first light-emitting control subline EML1 and the first reset control subline REL11. The first gate part GA41, the second gate part GA61, and the third gate part GA31 are located between the first light-emitting control subline EML1 and the second electrode plate C22 of the second capacitor C2, and the second gate part GA61 is located between the first gate part GA41 and the third gate part GA31. The fourth gate part GA11 is located between the third gate part GA31 and the first reset control subline REL11, and is distributed along the row direction X with the second electrode plate C22 of the second capacitor C2.

The first gate part GA41 overlaps with the active part ACT4 of the write transistor T4 to form the gate of the write transistor T4 (a bottom gate of the write transistor T4).

The second gate part GA61 overlaps with the active part ACT6 of the data control transistor T6 to form the gate of the data control transistor T6 (a bottom gate of the data control transistor T6).

The third gate part GA31 is connected to the second electrode plate C22 of the second capacitor C2 and may form an integral structure, or the third gate part GA31 may be regarded as a portion of the second electrode plate C22 of the second capacitor C2, that is, the second electrode plate C22 includes the third gate part GA31. Meanwhile, the third gate part GA31 may overlap with the active part ACT3 of the drive transistor T3 to form the gate of the drive transistor T3 (a bottom gate of the drive transistor T3). A length of the third gate part GA31 in the row direction X is not less than a length of the active part ACT3 of the drive transistor T3 in the row direction X, i.e., the width of the channel of the drive transistor T3.

The fourth gate part GA11 overlaps with the active parts ACT1 and ACT2 of the first reset transistor T1 and the second reset transistor T2 simultaneously, forming the gate of the first reset transistor T1 and the gate of the second reset transistor T2 (bottom gates of the first reset transistor T1 and the second reset transistor T2).

Further, in order to increase the capacity of the first capacitor C1, the first gate layer GA1 may further include a first capacitor extension GL1 and a second capacitor extension GL2.

The first capacitor extension GL1 may extend along an extension trajectory of the first shielding part BS2 and be connected or integrated with the first electrode plate C11. The first capacitor extension GL1 overlaps with the aforementioned first shielding part BS2, thereby forming a portion of the first capacitor C1. An orthographic projection of the first capacitor extension GL1 on the substrate SU is located within the orthographic projection of the first shielding part BS2 on the substrate SU, so that the first capacitor extension GL1 does not extend beyond a boundary of the first shielding part BS2.

The second capacitor extension GL2 may extend along an extension trajectory of the second shielding part BS4 and the third shielding part BS5 and be connected or integrated with the third gate part GA31. The second capacitor extension GL2 overlaps with the second shielding part BS4 and the third shielding part BS5, thereby forming a portion of the second capacitor C2. An orthographic projection of the second capacitor extension GL2 on the substrate SU is located within an orthographic projection of the second shielding part BS4 and the third shielding part BS5 on the substrate SU, so that the second capacitor extension GL2 does not extend beyond a boundary of the second shielding part BS4 and the third shielding part BS5.

As shown in FIGS. 5-9 and 12, for the first embodiment mentioned above, a contour of the third gate part GA31 may be the same as a contour of the second shielding body BS3, that is, the third gate part GA31 has an extension along the row direction X. The third gate part GA31 has two gate side edges GAL extending along the row direction X and distributed along the column direction Y. The third gate part GA31 may overlap with the active part ACT3 of the drive transistor T3 in the row direction X and be located within a boundary of the second shielding body BS3.

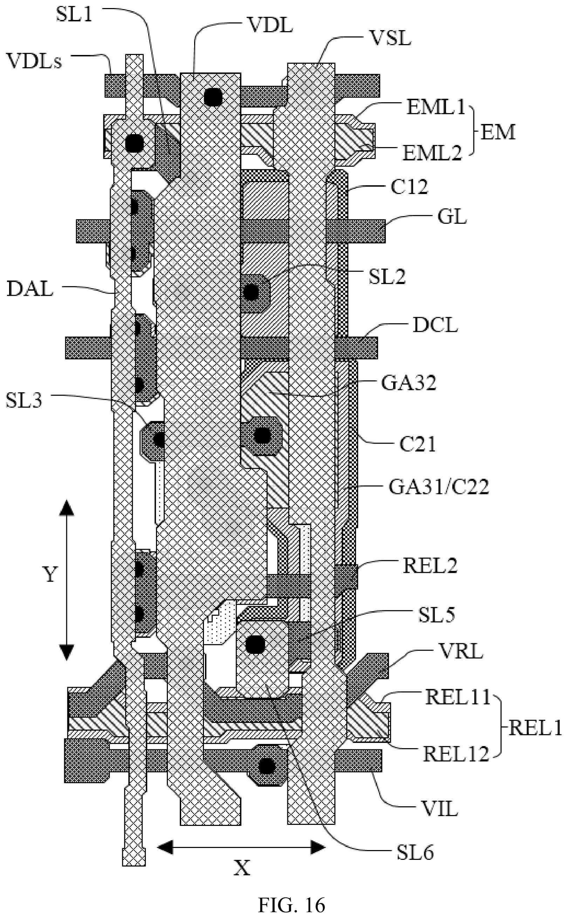

As shown in FIGS. 16-20 and 22, for the second embodiment mentioned above, the contour of the third gate part GA31 may be the same as that of the second shielding body BS3. The third gate part GA31 also protrudes towards the direction close to the first semiconductor part SE1, and a protruding part has two gate side edges GAL distributed along the column direction Y. A distance between the two gate side edges GAL decreases along the direction close to the first semiconductor part SE1, so that an extension direction of the two gate side edges GAL intersects with both the row direction X and the column direction Y. The third gate part GA31 may overlap with the active part ACT3 of the drive transistor T3 and be located within the boundary of the second shielding body BS3.

Semiconductor layer SE

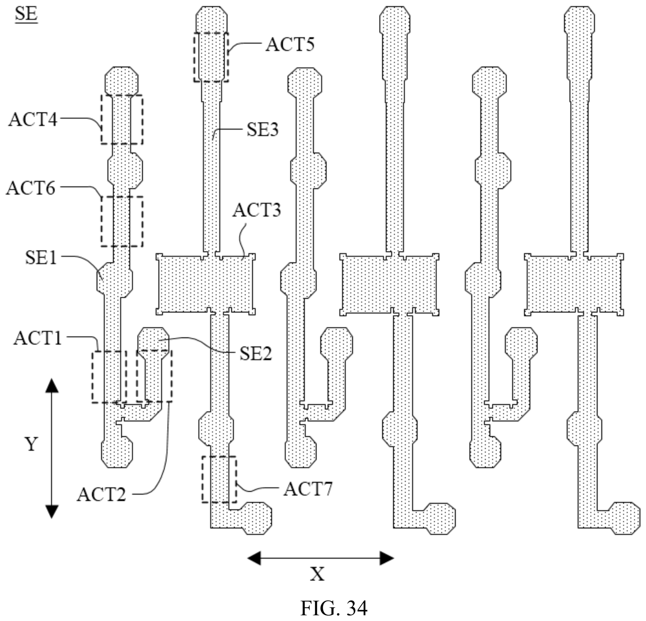

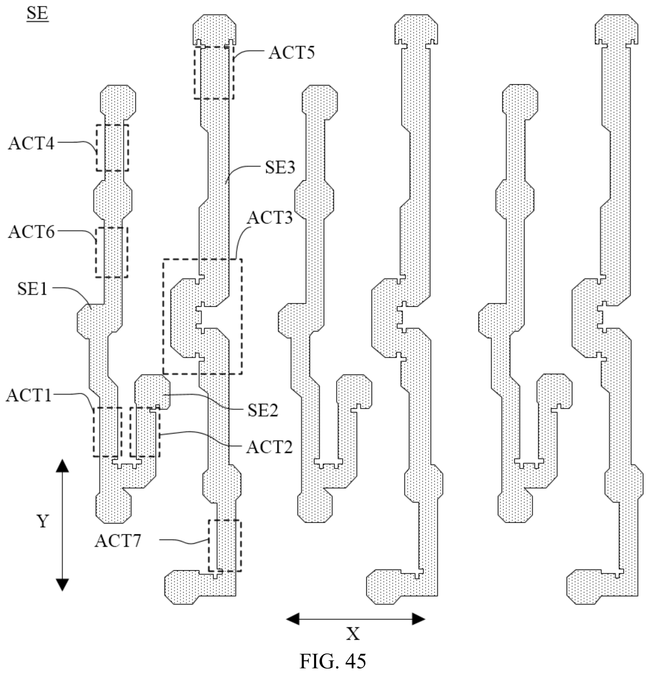

As shown in FIGS. 5-9, 12, 16-20, 23, 34, and 45, in some embodiments of the present disclosure, the semiconductor layer SE may include a first semiconductor part SE1, a second semiconductor part SE2, and a third semiconductor part SE3 spaced apart along the row direction X, and the specific patterns of them have been described above and will not be elaborated here.

Second gate layer GA2

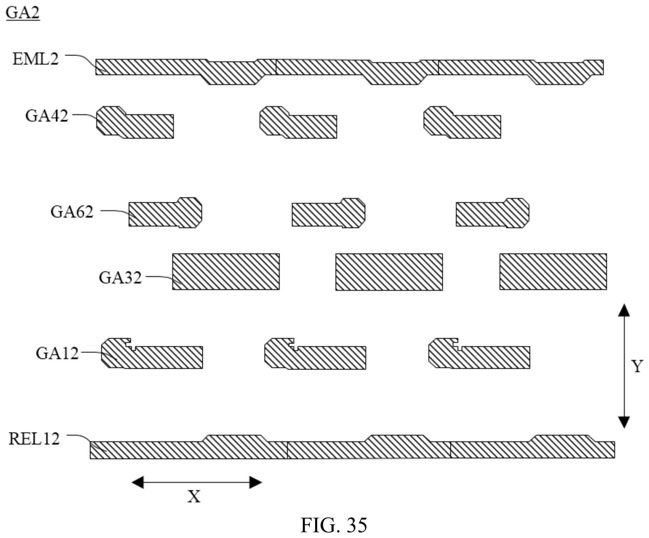

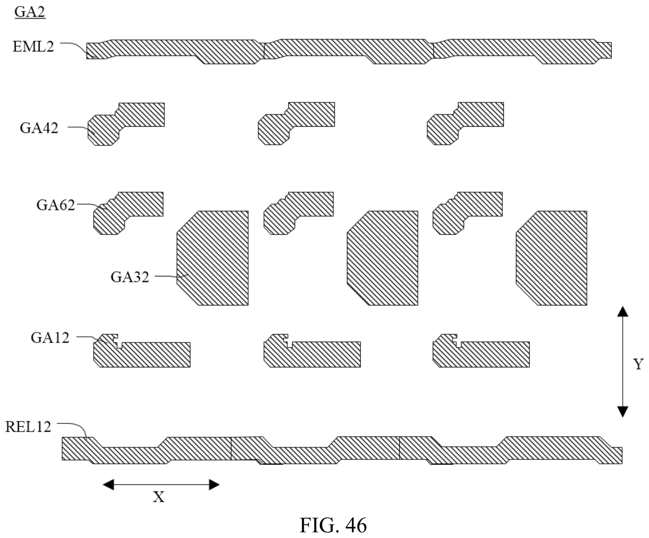

As shown in FIGS. 5-9, 13, 16-20, 24, 35, and 46, in some embodiments of the present disclosure, the second gate layer GA2 may further include a fifth gate part GA42, a sixth gate part GA62, a seventh gate part GA32, and an eighth gate part GA12. The second light-emitting control subline EML2, the fifth gate part GA42, the sixth gate part GA62, the seventh gate part GA32, the eighth gate part GA12, and the second reset control subline REL12 may be distributed in sequence along the column direction Y. The fifth gate part GA42, the sixth gate part GA62, the seventh gate part GA32, and the eighth gate part GA12 are located between the second light-emitting control subline EML2 and the second reset control subline REL12.

The fifth gate part GA42 overlaps with the active part ACT4 of the write transistor T4 and is connected to the first gate part GA41 to form the gate of the write transistor T4 (a top gate of the write transistor T4). Meanwhile, an orthographic projection of a region where the fifth gate part GA42 overlaps with the active part ACT4 of the write transistor T4 on the substrate SU is located within an orthographic projection of a region where the first gate part GA41 overlaps with the active part ACT4 of the write transistor T4 on the substrate SU.

The sixth gate part GA62 overlaps with the active part ACT6 of the data control transistor T6 and is connected to the second gate part GA61 to form the gate of the data control transistor T6 (a top gate of the data control transistor T6). Meanwhile, an orthographic projection of a region where the sixth gate part GA62 overlaps with the active part ACT6 of the data control transistor T6 on the substrate SU is located within an orthographic projection of a region where the second gate part GA61 overlaps with the active part ACT6 of the data control transistor T6 on the substrate SU.

The seventh gate part GA32 overlaps with the active part ACT3 of the drive transistor T3 to form the gate of the drive transistor T3 (a top gate of the drive transistor T3). A length of the seventh gate part GA32 in the row direction X is not less than the length of the active part ACT3 of the drive transistor T3 in the row direction X, that is, the width of the channel of the drive transistor T3. Meanwhile, an orthographic projection of a region where the seventh gate part GA32 overlaps with the active part ACT3 of the drive transistor T3 on the substrate SU is located within an orthographic projection of a region where the third gate part GA31 overlaps with the active part ACT3 of the drive transistor T3 on the substrate SU; the channel region of the drive transistor T3 is the region where the active part ACT3 overlaps with the seventh gate part GA32.

The eighth gate part GA12 overlaps with the active part ACT1 of the first reset transistor T1 and the active part ACT2 of the second reset transistor T2, and is connected to the fourth gate part GA11 to form the gates of the first reset transistor T1 and the second reset transistor T2 (top gates of the first reset transistor T1 and the second reset transistor T2). Meanwhile, an orthographic projection of a region where the eighth gate part GA12 overlaps with the active part ACT1 of the first reset transistor T1 on the substrate SU is located within an orthographic projection of a region where the fourth gate part GA11 overlaps with the active part ACT1 of the first reset transistor T1 on the substrate SU; an orthographic projection of a region where the eighth gate part GA12 overlaps with the active part ACT2 of the second reset transistor T2 on the substrate SU is located within an orthographic projection of a region where the fourth gate part GA11 overlaps with the active part ACT2 of the second reset transistor T2 on the substrate SU.

First source-drain layer SD1

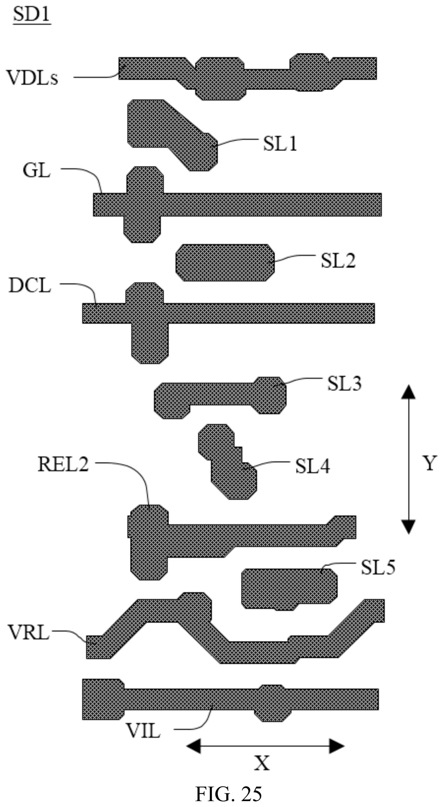

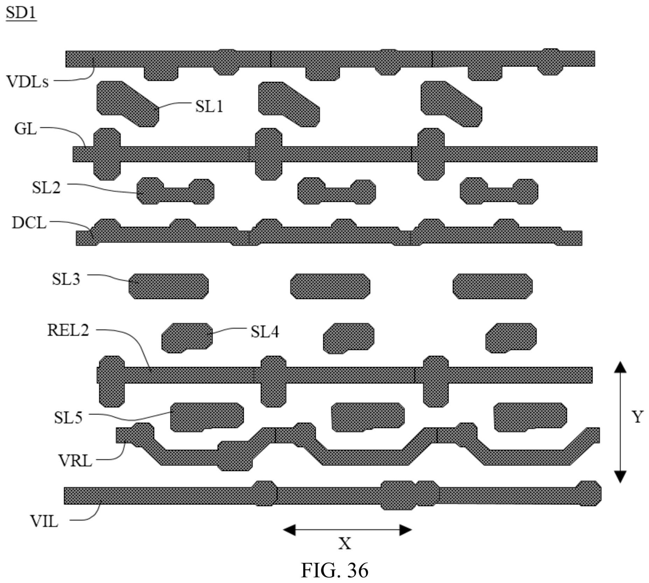

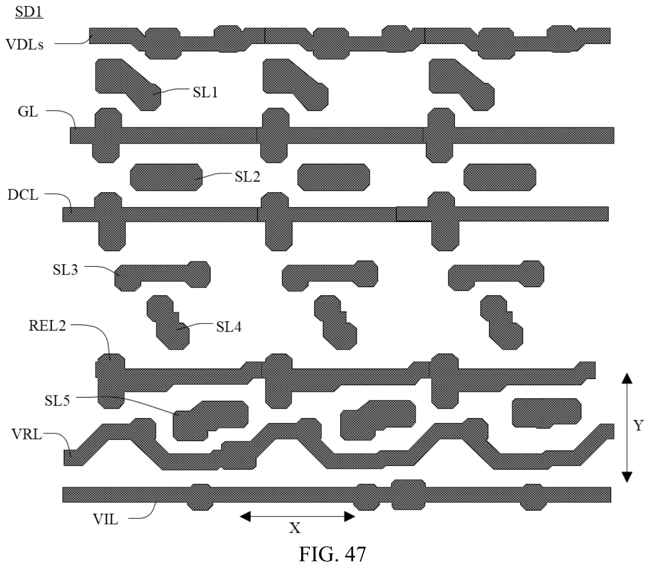

As shown in FIGS. 5-9, 14, 16-20, 25, 36, and 47, in some embodiments of the present disclosure, the first source-drain layer SD1 may include a first connection part SL1, a second connection part SL2, a third connection part SL3, a fourth connection part SL4, and a fifth connection part SL5; the first auxiliary power line VDLs, the scanning line GL, the data control line DCL, the second reset control line REL2, and the second reset line VIL may be distributed sequentially along the column direction Y. The first reset line VRL at least partially overlaps with the first reset control line REL1. For example, the first reset line VRL is located between the second reset line VIL and the second reset control line REL2, and partially overlaps with the first reset control line REL1.

The first connection part SL1 is located between the first auxiliary power line VDLs and the scanning line GL; the first connection part SL1 is connected to the data line DAL and the first electrode of the write transistor T4 through contact holes; and the data line DAL may transmit the data signal Data to the first electrode of the write transistor T4 through the first connection part SL1.

The second connection part SL2 is located between the scanning line GL and the data control line DCL; one end of the second connection part SL2 is connected to the first electrode plate C11 of the first capacitor C1 through a contact hole, and the other end thereof is connected to a region of the first semiconductor part SE1 located between the active part ACT4 of the write transistor T4 and the active part ACT6 of the data control transistor T6 through a contact hole, so that the first electrode plate C11 of the first capacitor C1, the first electrode of the write transistor T4, and the first electrode of the data control transistor T6 are connected to transmit the data signal Data. The second connection part SL2 is the N5 node of the pixel circuit.

The third connection part SL3 is located between the data control line DCL and the second reset control line REL2; one end of the third connection part SL3 is connected to the seventh gate part GA32 through a contact hole, and the other end thereof is connected to a region of the first semiconductor part SE1 located between the active part ACT1 of the first reset transistor T1 and the active part ACT6 of the data control transistor T6 through a contact hole, so that the gate (top gate) of the drive transistor T3, the second electrode of the data control transistor T6, and the second electrode of the first reset transistor T1 are connected through the third connection part SL3, to transmit the data signal Data and the reference signal Vref. The third connection part SL3 is the N1 node of the pixel circuit.

The fourth connection part SL4 is located between the third connection part SL3 and the second reset control line REL2; the fourth connection part SL4 is connected to one end of the second semiconductor part SE2 close to the drive transistor T3 and the first plate C21 of the second capacitor C2 through contact holes, so that the second electrode of the second reset transistor T2 and the first plate C21 of the second capacitor C2 are connected to transmit the reference signal Vref.

The fifth connection part SL5 is located between the second reset line VIL and the second reset control line REL2; one end of the fifth connection part SL5 is connected to the second electrode plate C22 of the second capacitor C2 through a contact hole, and the other end thereof is connected to a region of the third semiconductor part SE3 located between the active part ACT3 of the drive transistor T3 and the active part ACT7 of the third reset transistor T7 through a contact hole, so that the first electrode of the drive transistor T3, the second electrode plate C22 of the second capacitor C2, and the second electrode of the third reset transistor T7 are connected to transmit the reset signal Vinit.

The first auxiliary power line VDLs is connected to one end, away from the active part ACT3 of the drive transistor T3, of the active part ACT5 of the light-emitting control transistor T5 in the third semiconductor part SE3 through a contact hole, so that the first auxiliary reset line VRLs is connected to the first electrode of the light-emitting control transistor T5, to transmit the first power signal VDD. Meanwhile, one first auxiliary power line VDLs is connected to the first electrode of the light-emitting control transistor T5 in the same row of pixel circuits.

The scanning line GL is connected to both the first gate part GA41 and the fifth gate part GA42 through contact holes, and may simultaneously transmit the scanning signal Gate to the bottom and top gates of the write transistor T4.

The data control line DCL is connected to both the second gate part GA61 and the sixth gate part GA62 through contact holes, and may simultaneously transmit the data control signal DC to the bottom and top gates of the data control transistor T6.

The second reset control line REL2 is connected to both the fourth gate part GA11 and the eighth gate part GA12 through contact holes, and may simultaneously transmit the reference control signal RE2 to the bottom and top gates of the first reset transistor T1 and the second reset transistor T2.

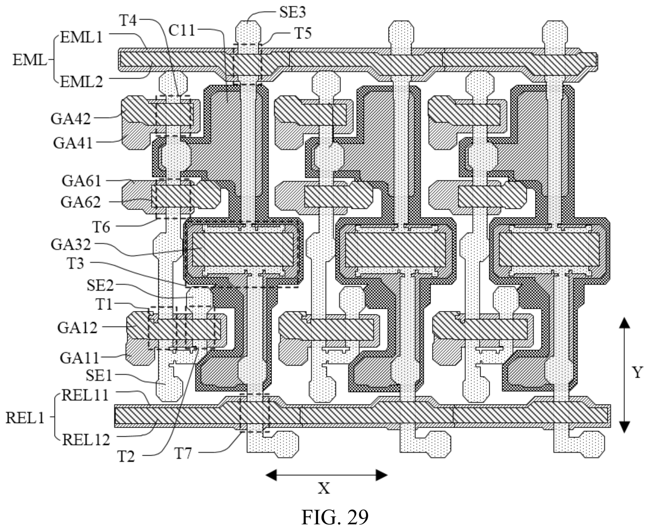

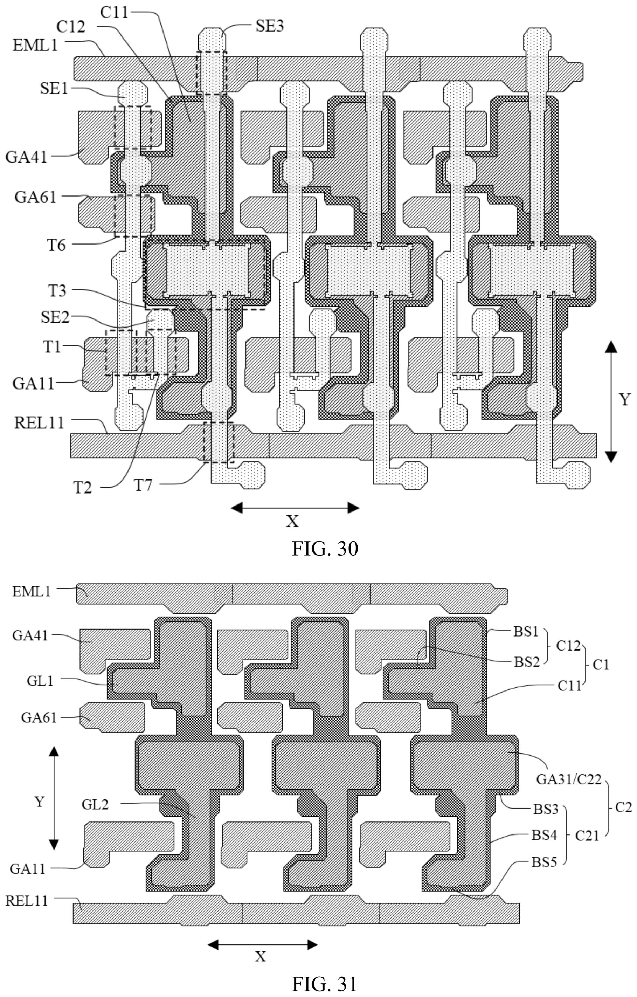

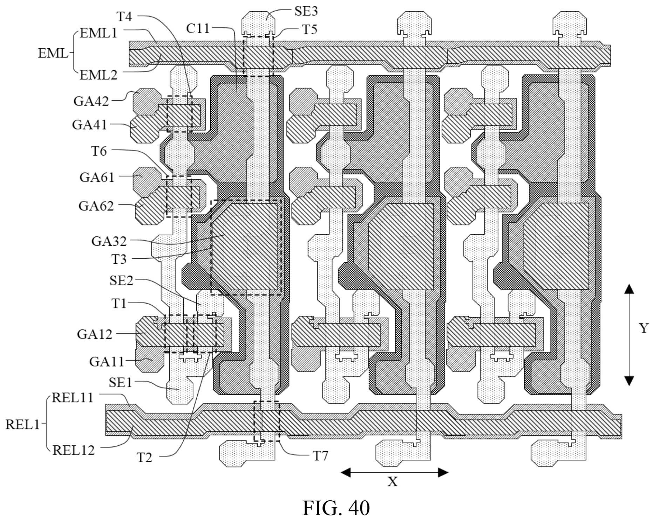

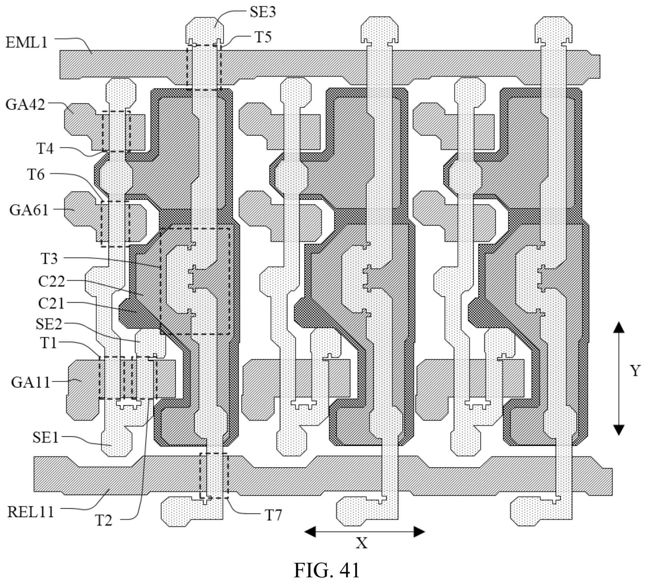

As shown in FIGS. 5-9, 14, 16-20, 25, 27-31, 36, 38-42, and 47, the first reset line VRL is connected to one end of the first semiconductor part SE1 away from the drive transistor T3, so as to be simultaneously connected to the first electrodes of the first reset transistor T1 and the second reset transistor T2. The reference signal Vref may be transmitted to both the first reset transistor T1 and the second reset transistor T2 through the first reset line VRL.

The second reset line VIL is connected to one end of the third semiconductor part SE3 away from the drive transistor T3 through a contact hole, so as to be connected to the first electrode of the third reset transistor T7, thereby transmitting the reset signal Vinit.

Second source-drain layer SD2

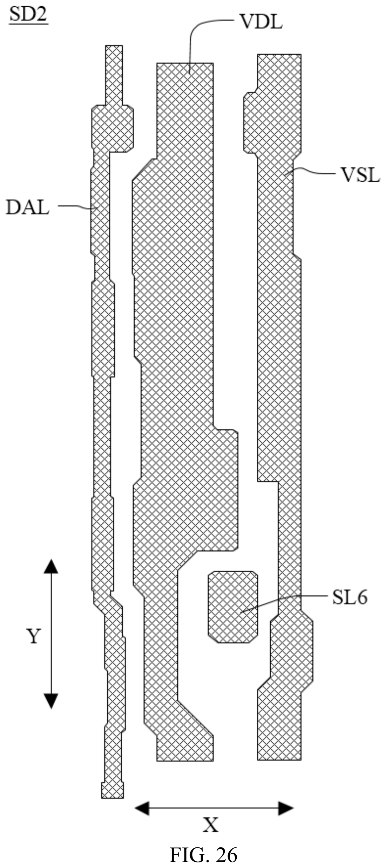

As shown in FIGS. 5-9, 15, 16-20, 26, 27-31, 37, 38-42, and 48, in some embodiments of the present disclosure, the second source-drain layer SD2 may include the data line DAL, the first power line VDL, and the second power line VSL mentioned above, and may also include the first auxiliary reset line VRLs and second auxiliary reset line VILs.

The data line DAL and the first power line VDL connected to a same pixel circuit form one column line group YG, overlapping with the pixel circuit. For example: The data line DAL overlaps with the first connection part SL1, the first gate part GA41, the fifth gate part GA42, the sixth gate part GA62, the fourth gate part GA11, and the eighth gate part GA12. Meanwhile, the data line DAL may be connected to the first connection part SL1 through a contact hole, so as to transmit the data signal Data to the first electrode of the write transistor T4 through the first connection part SL1.

The first power line VDL overlaps with the first semiconductor part SE1 and the second semiconductor part SE2, and overlaps with the active part ACT4 of the write transistor T4, the active part ACT6 of the data control transistor T6, the active part ACT1 of the first reset transistor T1, and the active part ACT2 of the second reset transistor T2. Channels of the write transistor T4, the data control transistor T6, the first reset transistor T1, and the second reset transistor T2 may be shielded by the first power line VDL, and since the first power signal VDD is a constant voltage signal, interference of the signal variation on a side of the first power line VDL away from the substrate SU to the transistors shielded by the first power line VDL may be reduced. Meanwhile, the first power line VDL may be connected to the first auxiliary power line VDLs through a contact hole, thereby forming a network for transmitting the first power signal VDD, which is beneficial for reducing impedance and ensuring uniform voltage of the first power signal VDD.

The second power line VSL, the first auxiliary reset line VRLs, and the second auxiliary reset line VILs overlap with different pixel circuits. For example, in three adjacent pixel circuits in the row direction X, three pixel circuits are each connected to one column line group YG; one pixel circuit overlaps with one second power line VSL, one pixel circuit overlaps with one first auxiliary reset line VRLs, and one pixel circuit overlaps with one second auxiliary reset line VILs. Regarding the second power line VSL, the first auxiliary reset line VRLs, the second auxiliary reset line VILs, and their respective overlapping pixel circuits:

The second power line VSL overlaps with the third semiconductor part SE3, and overlaps with the active part ACT5 of the light-emitting control transistor T5, the active part ACT3 of the drive transistor T3, and the active part ACT7 of the third reset transistor T7. Since the second power signal VSS is a constant voltage signal, the interference of signal variation on a side of the second power line VSL away from the substrate SU to the transistors shielded by the second power line VSL may be reduced. Meanwhile, in the display area AA, it may neither be connected to the second electrode CAT of the light-emitting device LD, nor be directly connected to the transistor of the pixel circuit; instead, it is connected to the second power bus in the peripheral area WA, which is beneficial for reducing impedance and ensuring uniform voltage of the second power signal VSS.

The first auxiliary reset line VRLs overlaps with the third semiconductor part SE3, and overlaps with the active part ACT5 of the light-emitting control transistor T5, the active part ACT3 of the drive transistor T3, and the active part ACT7 of the third reset transistor T7. Since the reference signal Vref is a constant voltage signal, the interference of signal variation on a side of the first auxiliary reset line VRLs away from the substrate SU to the transistors shielded by the first auxiliary reset line VRLs may be reduced. Meanwhile, the first auxiliary reset line VRLs is connected to the first reset line VRL through a contact hole, thereby forming a network for transmitting the reference signal Vref, which is conducive to reducing impedance and ensuring uniform voltage of the reference signal Vref.

The second auxiliary reset line VILs overlaps with the third semiconductor part SE3, and overlaps with the active part ACT5 of the light-emitting control transistor T5, the active part ACT3 of the drive transistor T3, and the active part ACT7 of the third reset transistor T7. Since the reset signal Vinit is a constant voltage signal, the interference of signal variation on a side of the second auxiliary reset line VILs away from the substrate SU to the transistors shielded by the second auxiliary reset line VILs. Meanwhile, the second auxiliary reset line VILs is connected to the second reset line VIL through a contact hole, thereby forming a network for transmitting the reset signal Vinit, which is beneficial for reducing impedance and ensuring uniform voltage of the reset signal Vinit.

In addition, as shown in FIGS. 5 and 16, in some embodiments of the present disclosure, for any one pixel circuit, the second source-drain layer SD2 may further include a sixth connection part SL6, which is located between the first power line VDL and the second power line VSL, second auxiliary reset line VILs, or first auxiliary reset line VRLs adjacent thereto. Meanwhile, the sixth connection part SL6 may be connected to the fifth connection part SL5 through a contact hole, and may be connected to the first electrode ANO of the light-emitting device LD through a contact hole, thereby connecting both the second electrode of the third reset transistor T7 and the first electrode of the drive transistor T3 to the first electrode ANO of the light-emitting device LD simultaneously.

The present disclosure also provides a display device that may include a display panel, which may be the display panel according to any one of the above embodiments, and the specific structure and beneficial effects of which will not be repeated herein. The display device according to the present disclosure may be a mobile phone, a tablet computer, a television, or may be other electronic devices with a display function, such as smart watches, smart glasses, and in-vehicle displays, which will not be enumerated herein.

Other embodiments of the present disclosure will be apparent to those skilled in the art from consideration of the specification and practice of the invention disclosed here. This application is intended to cover any variations, uses, or adaptations of the present disclosure following the general principles thereof and including such departures from the present disclosure as come within known or customary practice in the art. The specification and embodiments are considered to be merely exemplary, and the true scope and spirit of the present disclosure is indicated by the appended claims.

**Claims**

1.  A display panel, comprising a plurality of pixel circuits arranged in array along a row direction and a column direction, wherein each pixel circuit comprises a plurality of transistors, a first capacitor, and a second capacitor, and the transistors comprise a drive transistor, a write transistor, a light-emitting control transistor, a first reset transistor, a second reset transistor, and a third reset transistor;

    a first electrode of the light-emitting control transistor is configured to receive a first power signal, and a second electrode of the light-emitting control transistor is connected to a second electrode of the drive transistor; a first electrode of the write transistor is configured to receive a data signal, a second electrode of the write transistor is connected to a gate of the drive transistor and a first electrode plate of the first capacitor, a second electrode plate of the first capacitor is connected to a first electrode plate of the second capacitor, and a second electrode plate of the second capacitor is connected to a first electrode of the drive transistor;

    a first electrode of the first reset transistor and a first electrode of the second reset transistor are configured to receive a reference signal, and a second electrode of the first reset transistor is connected to the gate of the drive transistor; a second electrode of the second reset transistor is connected to the second electrode plate of the first capacitor and the first electrode plate of the second capacitor; a first electrode of the third reset transistor is configured to receive a reset signal, and a second electrode of the third reset transistor is connected to the first electrode of the drive transistor and the second electrode plate of the second capacitor;

    the display panel comprises:

    a substrate;
    a semiconductor layer arranged on a side of the substrate and comprising an active part of each of the transistors; and
    a plurality of light-emitting devices arranged on a side of the semiconductor layer away from the substrate, one of the light-emitting devices being connected to the first electrode of the drive transistor of one pixel circuit,
    wherein one of the first electrode plate and the second electrode plate of the first capacitor is arranged on a same layer as one of the first electrode plate and the second electrode plate of the second capacitor; one of the first capacitor and the second capacitor overlaps with an active part of the drive transistor.

2.  The display panel according to claim 1, wherein the first electrode plate of the first capacitor and the second electrode plate of the second capacitor are arranged on the same layer and distributed along the column direction; the second electrode plate of the first capacitor and the first electrode plate of the second capacitor are arranged on the same layer and have an integrated structure; the first electrode plate and the second electrode plate of the second capacitor overlap with the active part of the drive transistor.

3.  The display panel according to claim 2, wherein the pixel circuit further comprises a data control transistor, a first electrode of the data control transistor being connected to the second electrode of the write transistor and the first electrode plate of the first capacitor, and a second electrode of the data control transistor is connected to the gate of the drive transistor.

4.  The display panel according to claim 3, wherein the semiconductor layer comprises a first semiconductor part, a second semiconductor part, and a third semiconductor part spaced apart along the row direction; the second semiconductor part is located between the first semiconductor part and the third semiconductor part, and the first semiconductor part is connected to the second semiconductor part; active parts of the write transistor, the data control transistor, and the first reset transistor are all located in the first semiconductor part and are sequentially connected along the column direction; an active part of the second reset transistor is located in the second semiconductor part; active parts of the light-emitting control transistor, the drive transistor, and the third reset transistor are located in the third semiconductor part and are sequentially connected along the column direction.

5. The display panel according to claim 4, wherein the third semiconductor part comprises a first semiconductor segment and a second semiconductor segment distributed along the column direction; the active part of the drive transistor is connected between the first semiconductor segment and the second semiconductor segment; a width of the active part of the drive transistor in the row direction is greater than a width of the first semiconductor segment in the row direction and a width of the second semiconductor segment in the row direction.

6. The display panel according to claim 5, wherein the width of the active part of the drive transistor in the row direction is not less than 6 $\mu$m and not greater than 20 $\mu$m.

7. The display panel according to claim 4, wherein the third semiconductor part comprises a first semiconductor segment and a second semiconductor segment distributed along the column direction; the active part of the drive transistor is connected between the first semiconductor segment and the second semiconductor segment; the active part of the drive transistor is bent towards and/or away from the first semiconductor part along the row direction.

8. The display panel according to claim 7, wherein a length of the active part of the drive transistor in its extension direction is not less than 20 $\mu$m and not greater than 30 $\mu$m.

9. The display panel according to claim 1, wherein a width-to-length ratio of the drive transistor is not greater than 20/6 and not less than 4/30.

10. The display panel according to claim 4, wherein the first electrode plate and the second electrode plate of the first capacitor overlap with the third semiconductor part and the first semiconductor part.

11. The display panel according to claim 1, wherein a capacitance of the second capacitor is greater than a capacitance of the first capacitor.

12. The display panel according to claim 4, wherein the display panel further comprises:

a light-emitting control line extending along the row direction and overlapping with the active part of the light-emitting control transistor, and configured to transmit a light-emitting control signal;
a first reset control line extending along the row direction and overlapping with the active part of the third reset transistor, and configured to transmit a reset control signal;
a second reset control line connected to a gate of the first reset transistor and a gate of the second reset transistor, and configured to transmit a reference control signal;
a scanning line extending along the row direction and connected to a gate of the write transistor, and configured to transmit a scanning signal;
a data control line extending along the row direction and connected to a gate of the data control transistor, and configured to transmit a data control signal;
a first reset line extending along the row direction and connected to the first electrode of the first reset transistor and the first electrode of the second reset transistor, and configured to transmit the reference signal; and
a second reset line extending along the row direction and connected to the first electrode of the third reset transistor, and configured to transmit the reset signal.

13. The display panel according to claim 12, wherein orthographic projections of the light-emitting control line, the scanning line, the data control line, the second reset control line, the first reset control line, and the second reset line on the substrate are sequentially spaced apart along the column direction; the first reset line overlaps with the first reset control line;

an orthographic projection of the active part of the drive transistor on the substrate is located between the orthographic projections of the data control line and the second reset control line on the substrate;
orthographic projections of the active part of the write transistor and the first capacitor on the substrate are at least partially located between the orthographic projections of the light-emitting control line and the data control line on the substrate;

orthographic projections of the active parts of the first reset transistor and the second reset transistor on the substrate are located between the orthographic projections of the data control line and the first reset control line on the substrate.

14. The display panel according to claim 13, wherein the display panel further comprises:

a plurality of first auxiliary power lines extending along the row direction and distributed along the column direction, wherein one first auxiliary power line is provided between two adjacent rows of pixel circuits, and the first auxiliary power line is connected to the first electrode of the light-emitting control transistor of one row of pixel circuits on one side of the first auxiliary power line;
a plurality of first power lines arranged on a side of the first auxiliary power lines away from the substrate, wherein the first power line extend along the column direction and are spaced apart along the row direction, and one first power line is connected to each of the first auxiliary power lines and overlaps with one column of pixel circuits; and
a plurality of data lines arranged on the side of the first auxiliary power lines away from the substrate, wherein the data lines extend along the column direction and are spaced apart along the row direction, and one data line overlaps with one column of pixel circuits and is connected to the first electrode of the write transistor and is configured to transmit the data signal.

15. The display panel according to claim 14, wherein the display panel further comprises:

a plurality of second power lines, a plurality of first auxiliary reset lines, and a plurality of second auxiliary reset lines, extending along the column direction, distributed along the row direction, and arranged on the side of the first auxiliary power lines away from the substrate, wherein each second power line is configured to transmit a second power signal, each first auxiliary reset line is connected to the first reset line, and each second auxiliary reset line is connected to the second reset line;
the first power line and the data line connected to a same column of pixel circuits are defined as a line group, and one of the second power line, the first auxiliary reset line, and the second auxiliary reset line is provided between two adjacent line groups;

the light-emitting device has a first electrode and a second electrode, the first electrode being connected to the first electrode of the drive transistor, and the second electrode being connected to the second power line.

16. The display panel according to claim 15, wherein the light-emitting control line comprises a first light-emitting control subline and a second light-emitting control subline arranged along a direction away from the substrate, and both the first light-emitting control subline and the second light-emitting control subline extend along the row direction and are connected;
the first reset control line comprises a first reset control subline and a second reset control subline arranged along the direction away from the substrate, and both the first reset control subline and the second reset control subline extend along the row direction and are connected.

17. The display panel according to claim 16, wherein the display panel further comprises:

a light-shielding layer arranged on the side of the substrate and comprising the second electrode plate of the first capacitor and the first electrode plate of the second capacitor;
a first gate layer arranged on a side of the light-shielding layer away from the substrate and comprising the first electrode plate of the first capacitor, the second electrode plate of the second capacitor, the first light-emitting control subline, and the first reset control subline; the semiconductor layer being arranged on a side of the first gate layer away from the substrate;
a second gate layer arranged on the side of the semiconductor layer away from the substrate and comprising the second light-emitting control subline and the second reset control subline;
a first source-drain layer arranged on a side of the second gate layer away from the substrate and comprising the first auxiliary power line, the scanning line, the data control line, the second reset control line, the first reset line, and the second reset line; and
a second source-drain layer arranged on a side of the first source-drain layer away from the substrate and comprising the data line, the first power line, the second power line, the first auxiliary reset line, and the second auxiliary reset line.

18. The display panel according to claim 17, wherein the first gate layer further comprises:

a first gate part overlapping with the active part of the write transistor to form the gate of the write transistor;

a second gate part overlapping with the active part of the data control transistor, to form the gate of the data control transistor; the first electrode plate of the second capacitor comprising a third gate part; and

a fourth gate part overlapping with the active part of the first reset transistor and the active part of the second reset transistor, to form the gate of the first reset transistor and the gate of the second reset transistor.

19. The display panel according to claim 18, wherein the second gate layer comprises:

a fifth gate part overlapping with the active part of the write transistor and connected to the first gate part, to form the gate of the write transistor; a sixth gate part overlapping with the active part of the data control transistor and connected to the second gate part, to form the gate of the data control transistor; a seventh gate part overlapping with the active part of the drive transistor and connected to the third gate part, to form the gate of the drive transistor; and

an eighth gate part overlapping with the active part of the first reset transistor and the active part of the second reset transistor and connected to the fourth gate part, to form the gate of the first reset transistor and the gate of the second reset transistor.

20. The display panel according to claim 19, wherein the first source-drain layer comprises:

a first connection part located between the first auxiliary power line and the scanning line, and connected to the data line and the first electrode of the write transistor;

a second connection part located between the scanning line and the data control line, and connected to the first electrode plate of the first capacitor and a region of the first semiconductor part located between the active part of the write transistor and the active part of the data control transistor;

a third connection part located between the data control line and the second reset control line, and connected to the seventh gate part and a region of the first semiconductor part located between the active part of the first reset transistor and the active part of the data control transistor;

a fourth connection part located between the third connection part and the second reset control line, and connected to the first electrode plate of the second capacitor and an end of the second semiconductor part close to the active part of the drive transistor; an end of the second semiconductor part away from the active part of the drive transistor being connected to the first semiconductor part; and

a fifth connection part located between the first reset control line and the second reset control line, and connected to the second electrode plate of the second capacitor and a region of the third semiconductor part located between the active part of the drive transistor and the active part of the third reset transistor.

21. The display panel according to any one of claims 1-20, wherein a material of the semiconductor layer comprises a metal oxide.

22. A display device comprising the display panel according to any one of claims 1-21.

FIG. 1

FIG. 2

FIG. 3

FIG. 4

FIG. 5

FIG. 6

FIG. 7

FIG. 8

FIG. 9

FIG. 10

GA1

EML1

GA41

GL1

C11

GA61

GAL

GA31/C22

GAL

Y

GA11

GL2

X

REL11

FIG. 11

FIG. 12

GA2

EML2

GA42

GA62

GA32

Y

GA12

REL12

X

FIG. 13

SD1

FIG. 14

FIG. 15

FIG. 16

FIG. 17

FIG. 18

FIG. 19

FIG. 20

FIG. 21

GA1

EML1

GA41

GL1

C11

GA61

GAL

GA31/C22

GAL

GA11

REL11    GL2

Y

X

FIG. 22

FIG. 23

FIG. 24

SD1

VDLs

SL1

GL

SL2

DCL

SL3

SL4

REL2

Y

SL5

VRL

VIL

X

FIG. 25

SD2

VDL

DAL

VSL

SL6

Y

X

FIG. 26

FIG. 27

FIG. 28

FIG. 29

FIG. 30

FIG. 31

BSM

FIG. 32

GA1

FIG. 33

FIG. 34

FIG. 35

SD1

FIG. 36

SD2

FIG. 37

FIG. 38

FIG. 39

FIG. 40

FIG. 41

C12    C11

EML1

GA41

GL1

GA61

GA31/C22

C21

GA11

REL11

FIG. 42

BSM

BS1
C12
BS2

BSL

BS3

C21    BS4

BS5    BSL

X

Y

FIG. 43

<u>GA1</u>

EML1 —
GA41 —
GL1 —
GA61 —
GAL —
GA31/C22 —
GAL —
GA11 —
REL11 —
GL2 —

C11

X

Y

FIG.44

FIG. 45

FIG. 46

FIG. 47

FIG. 48

## INTERNATIONAL SEARCH REPORT

| International application No. |
|---|
| **PCT/CN2023/143177** |

| | |
|---|---|
| **A.** | **CLASSIFICATION OF SUBJECT MATTER** |
| | G09G3/3233(2016.01)i; H10K59/12(2023.01)i |

According to International Patent Classification (IPC) or to both national classification and IPC

| | |
|---|---|
| **B.** | **FIELDS SEARCHED** |

Minimum documentation searched (classification system followed by classification symbols)

IPC:G09G3 G09G5 H01L27 H01L51 H10K59

Documentation searched other than minimum documentation to the extent that such documents are included in the fields searched

Electronic data base consulted during the international search (name of data base and, where practicable, search terms used)

CNTXT, DWPI, ENTXT, ENTXTC, USTXT, WPABS, CJFD, CNKI, IEEE: 串接, 串联, 第二储存, 第二存储, 第二电容, 数据信号, 干扰, 宽长比, 扰动, 像素, serial, second, two, apacitor, capacitance, connect+, breadth length rtio, disturb+, pixel

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| Y | CN 116169146 A (SAMSUNG DISPLAY CO., LTD.) 26 May 2023 (2023-05-26) description, paragraphs 42-102, and figures 1-17 | 1-12, 21-22 |
| Y | US 2023154402 A1 (BOE TECHNOLOGY GROUP CO., LTD.) 18 May 2023 (2023-05-18) description, paragraphs 157-169, and figures 6, 15 and 20 | 1-12, 21-22 |
| Y | US 2021104196 A1 (XIAMEN TIANMA MICRO-ELECTRONICS CO., LTD.) 08 April 2021 (2021-04-08) description, paragraph 38 | 5-9, 21-22 |
| A | CN 101739947 A (SAMSUNG MOBILE DISPLAY CO., LTD.) 16 June 2010 (2010-06-16) entire document | 1-22 |
| A | CN 101866614 A (SAMSUNG MOBILE DISPLAY CO., LTD.) 20 October 2010 (2010-10-20) entire document | 1-22 |
| A | CN 103578416 A (LG DISPLAY CO., LTD.) 12 February 2014 (2014-02-12) entire document | 1-22 |

☑ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **15 March 2024** | **30 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/143177** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 106952615 A (BOE TECHNOLOGY GROUP CO., LTD. et al.) 14 July 2017 (2017-07-14)<br>entire document | 1-22 |
| A | CN 110914894 A (HUAWEI TECHNOLOGIES CO., LTD.) 24 March 2020 (2020-03-24)<br>entire document | 1-22 |
| A | CN 111243479 A (BOE TECHNOLOGY GROUP CO., LTD.) 05 June 2020 (2020-06-05)<br>entire document | 1-22 |
| A | US 2011164016 A1 (KANG CHUL-KYU et al.) 07 July 2011 (2011-07-07)<br>entire document | 1-22 |
| A | US 2018122301 A1 (LG DISPLAY CO., LTD.) 03 May 2018 (2018-05-03)<br>entire document | 1-22 |
| A | US 2023036497 A1 (SAMSUNG DISPLAY CO., LTD.) 02 February 2023 (2023-02-02)<br>entire document | 1-22 |
| A | US 2023154403 A1 (SAMSUNG DISPLAY CO., LTD.) 18 May 2023 (2023-05-18)<br>entire document | 1-22 |
| A | US 2023200129 A1 (BOE TECHNOLOGY GROUP CO., LTD.) 22 June 2023 (2023-06-22)<br>entire document | 1-22 |

Form PCT/ISA/210 (second sheet) (July 2022)

**INTERNATIONAL SEARCH REPORT**
Information on patent family members

International application No.

**PCT/CN2023/143177**

| Patent document cited in search report | | | Publication date (day/month/year) | Patent family member(s) | | | Publication date (day/month/year) |
|---|---|---|---|---|---|---|---|
| CN | 116169146 | A | 26 May 2023 | US | 2023162679 | A1 | 25 May 2023 |
| | | | | KR | 20230077804 | A | 02 June 2023 |
| US | 2023154402 | A1 | 18 May 2023 | DE | 112021001804 | T5 | 05 January 2023 |
| | | | | US | 2023200129 | A1 | 22 June 2023 |
| | | | | WO | 2022160535 | A1 | 04 August 2022 |
| | | | | WO | 2022160125 | A1 | 04 August 2022 |
| | | | | US | 11688343 | B2 | 27 June 2023 |
| | | | | CN | 115298830 | A | 04 November 2022 |
| US | 2021104196 | A1 | 08 April 2021 | US | 11211010 | B2 | 28 December 2021 |
| | | | | CN | 112102785 | A | 18 December 2020 |
| | | | | CN | 213277408 | U | 25 May 2021 |
| | | | | US | 2022148506 | A1 | 12 May 2022 |
| | | | | US | 11605344 | B2 | 14 March 2023 |
| | | | | US | 2023230547 | A1 | 20 July 2023 |
| | | | | US | 2023267891 | A1 | 24 August 2023 |
| CN | 101739947 | A | 16 June 2010 | JP | 2010128491 | A | 10 June 2010 |
| | | | | JP | 5064421 | B2 | 31 October 2012 |
| | | | | KR | 20100059318 | A | 04 June 2010 |
| | | | | KR | 100986915 | B1 | 08 October 2010 |
| | | | | EP | 2192571 | A2 | 02 June 2010 |
| | | | | EP | 2192571 | A3 | 09 June 2010 |
| | | | | EP | 2192571 | B1 | 23 August 2017 |
| | | | | US | 2010127956 | A1 | 27 May 2010 |
| | | | | US | 8654041 | B2 | 18 February 2014 |
| | | | | CN | 101739947 | B | 12 December 2012 |
| CN | 101866614 | A | 20 October 2010 | KR | 20100115062 | A | 27 October 2010 |
| | | | | KR | 101008482 | B1 | 14 January 2011 |
| | | | | EP | 2242039 | A1 | 20 October 2010 |
| | | | | EP | 2242039 | B1 | 02 November 2011 |
| | | | | JP | 2010250260 | A | 04 November 2010 |
| | | | | JP | 5074468 | B2 | 14 November 2012 |
| | | | | US | 2010265166 | A1 | 21 October 2010 |
| | | | | US | 8907870 | B2 | 09 December 2014 |
| | | | | CN | 101866614 | B | 14 August 2013 |
| CN | 103578416 | A | 12 February 2014 | US | 2016078816 | A1 | 17 March 2016 |
| | | | | US | 9466243 | B2 | 11 October 2016 |
| | | | | KR | 20140017738 | A | 12 February 2014 |
| | | | | KR | 101935955 | B1 | 04 April 2019 |
| | | | | US | 2014035799 | A1 | 06 February 2014 |
| | | | | US | 9224337 | B2 | 29 December 2015 |
| | | | | CN | 103578416 | B | 10 August 2016 |
| CN | 106952615 | A | 14 July 2017 | US | 2020342812 | A1 | 29 October 2020 |
| | | | | WO | 2018210329 | A1 | 22 November 2018 |
| | | | | CN | CN106952615 | B | 01 February 2019 |
| CN | 110914894 | A | 24 March 2020 | WO | 2019014939 | A1 | 24 January 2019 |
| CN | 111243479 | A | 05 June 2020 | WO | 2021143752 | A1 | 22 July 2021 |
| | | | | US | 2022199022 | A1 | 23 June 2022 |
| | | | | US | 11908404 | B2 | 20 February 2024 |
| US | 2011164016 | A1 | 07 July 2011 | US | 8284136 | B2 | 09 October 2012 |

Form PCT/ISA/210 (patent family annex) (July 2022)

## INTERNATIONAL SEARCH REPORT
### Information on patent family members

International application No.

**PCT/CN2023/143177**

| Patent document cited in search report | | | Publication date (day/month/year) | Patent family member(s) | | | Publication date (day/month/year) |
|---|---|---|---|---|---|---|---|
| | | | | KR | 20110080388 | A | 13 July 2011 |
| | | | | KR | 101074811 | B1 | 19 October 2011 |
| US | 2018122301 | A1 | 03 May 2018 | KR | 101856378 | B1 | 20 June 2018 |
| | | | | US | 10198996 | B2 | 05 February 2019 |
| | | | | CN | 108010485 | A | 08 May 2018 |
| | | | | CN | 108010485 | B | 15 September 2020 |
| US | 2023036497 | A1 | 02 February 2023 | US | 11741887 | B2 | 29 August 2023 |
| | | | | KR | 20230020073 | A | 10 February 2023 |
| | | | | CN | 115701630 | A | 10 February 2023 |
| US | 2023154403 | A1 | 18 May 2023 | US | 11705066 | B2 | 18 July 2023 |
| | | | | US | 2023298525 | A1 | 21 September 2023 |
| | | | | KR | 20230072582 | A | 25 May 2023 |
| | | | | CN | 116137131 | A | 19 May 2023 |
| US | 2023200129 | A1 | 22 June 2023 | CN | 115298830 | A | 04 November 2022 |
| | | | | DE | 112021001804 | T5 | 05 January 2023 |
| | | | | US | 2023154402 | A1 | 18 May 2023 |
| | | | | US | 11688343 | B2 | 27 June 2023 |
| | | | | WO | 2022160125 | A1 | 04 August 2022 |
| | | | | WO | 2022160535 | A1 | 04 August 2022 |

Form PCT/ISA/210 (patent family annex) (July 2022)

**EP 4 723 088 A1**

**REFERENCES CITED IN THE DESCRIPTION**

**Patent documents cited in the description**

- CN 202310628545